(19) Europäisches Patentamt
European Patent Office
Office européen des brevets

(11) **EP 4 557 005 A2**

(12) **EUROPEAN PATENT APPLICATION**

(43) Date of publication:
**21.05.2025 Bulletin 2025/21**

(21) Application number: **25168469.2**

(22) Date of filing: **15.02.2023**

(51) International Patent Classification (IPC):
***G03F 7/40*** *(2006.01)*

(52) Cooperative Patent Classification (CPC):
**G03F 7/0392; G03F 7/0045; G03F 7/0397; G03F 7/40**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **18.02.2022 JP 2022024091**

(62) Document number(s) of the earlier application(s) in accordance with Art. 76 EPC:
**23705389.7 / 4 479 801**

(71) Applicant: **Merck Patent GmbH**
**64293 Darmstadt (DE)**

(72) Inventors:
- **Yano, Tomotsugu**
  **Kakegawa-shi, 437-1412 (JP)**
- **Hama, Yusuke**
  **Kakegawa-shi, 437-1412 (JP)**
- **Hitokawa, Hiroshi**
  **Kakegawa-shi, 437-1412 (JP)**

(74) Representative: **Merck Patent Association**
**Merck Patent GmbH**
**64271 Darmstadt (DE)**

Remarks:
This application was filed on 04.04.2025 as a divisional application to the application mentioned under INID code 62.

(54) **POSITIVE TYPE LIFT-OFF RESIST COMPOSITION AND METHOD FOR MANUFACTURING RESIST PATTERN USING THE SAME**

(57) [Problem] A positive type lift-off resist composition is provided.

[Means for Solution] A positive type lift-off resist composition comprising a polymer (A) having a certain structure and cLogP of 2.76 to 3.35, a photoacid generator (B) and a solvent (C).

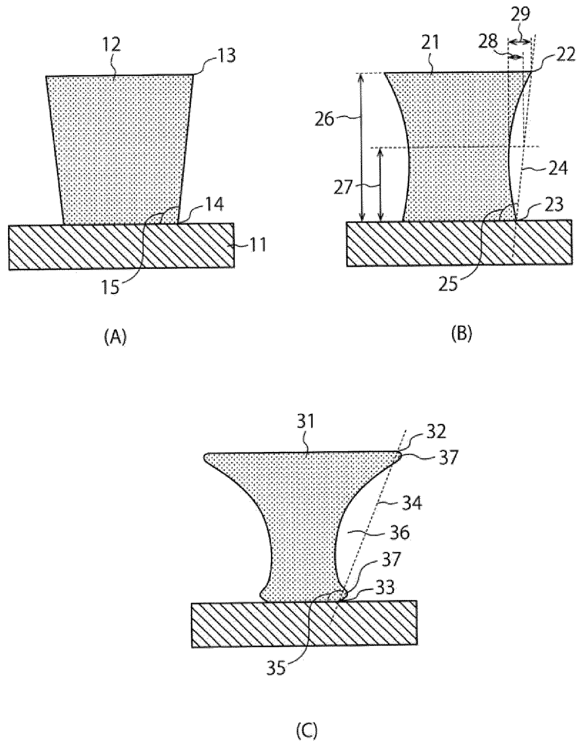


Figure 1



EP 4 557 005 A2

## Description

### BACKGROUND OF THE INVENTION

### TECHNICAL FIELD

The present invention relates to a positive type lift-off resist composition and a method for manufacturing a resist pattern using the same.

### BACKGROUND ART

In a process of manufacturing devices such as semiconductor, fine processing by lithographic technique using a photoresist has generally been employed. The fine processing process comprises forming a thin photoresist layer on a semiconductor substrate such as a silicon wafer, covering the layer with a mask pattern corresponding to a desired device pattern, exposing the layer with actinic ray such as ultraviolet ray through the mask, developing the exposed layer to obtain a photoresist pattern, and etching the substrate using the resulting photoresist pattern as a protective film, thereby forming fine unevenness corresponding to the above-described pattern.

A lift-off method is known, which comprises forming a film of a material such as metal on the formed resist pattern by vapor deposition or the like, removing the resist by a solvent, thereby removing the material on the resist pattern and remaining the material such as metal only in an area where the resist pattern is not formed.

In order to carry out the lift-off method, it is preferable that the resist pattern is a reverse tapered shape, and a negative type resist composition is often used because the reverse tapered shape can be easily formed. For example, it has been proposed to form a reverse tapered shape using a negative type resist composition containing a cross-linking agent (Patent Document 1).

In general, exposure light does not sufficiently reach the lower portion of the resist film, the generation of acid is suppressed in the lower portion of the resist film, and the acid generated in the lower portion of the resist film is deactivated by the influence of the substrate. Therefore, a resist pattern formed using a positive type resist composition tends to have a tapered shape (footing shape).

As a method for forming a resist pattern having a reverse tapered shape using a positive type resist composition, a method using a positive type resist composition containing a dissolution rate modifier has been proposed (Patent Document 2).

### PRIOR ART DOCUMENTS

### PATENT DOCUMENTS

[Patent document 1] WO 2017/169866
[Patent document 2] WO 2020/193686

### SUMMARY OF THE INVENTION

### PROBLEMS TO BE SOLVED BY THE INVENTION

The present inventors have considered that there are one or more problems still need improvements in the positive type lift-off resist composition and the method for manufacturing a resist pattern using the same. They include, for example, the following:
Sufficient resolution cannot be obtained; difficult to form resist pattern shapes suitable for lift-off; sensitivity of the resist composition is insufficient; difficult to form resist pattern shapes of thin film; heat resistance of the resist pattern is insufficient; solubility of the resist film in the exposed area cannot be adequately controlled; and difficult for developer dissolve the soluble area sufficiently.

The present invention has been made based on the technical background as described above, and provides a positive type lift-off resist composition and a method for manufacturing a resist pattern using the same.

### MEANS FOR SOLVING THE PROBLEMS

The positive type lift-off resist composition according to the present invention comprises a polymer (A), a

photoacid generator (B) and a solvent (C),
wherein,

cLogP of the polymer (A) is 2.76 to 3.35,
the polymer (A) comprises at least one of the repeating units represented by formulae (A-1) to (A-4), and
the content of a dissolution rate modifier (D) is 0 to 1.0 mass parts with respect to 100 mass parts of the polymer (A), and the dissolution rate modifier (D) is represented by the formula (D-1):

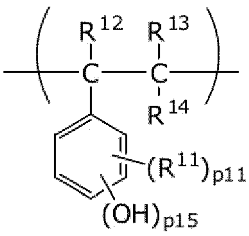
(A-1)

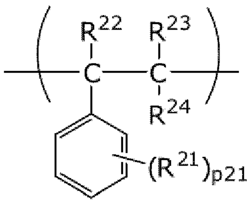
(A-2)

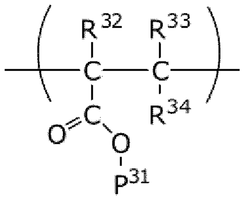
(A-3)

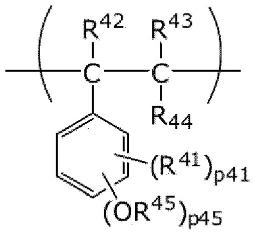
(A-4)

where

$R^{11}$, $R^{21}$, $R^{41}$ and $R^{45}$ are each independently $C_{1-5}$ alkyl (where $-CH_2-$ in the alkyl can be replaced with -O-);
$R^{12}$, $R^{13}$, $R^{14}$, $R^{22}$, $R^{23}$, $R^{24}$, $R^{32}$, $R^{33}$, $R^{34}$, $R^{42}$, $R^{43}$ and $R^{44}$ are each independently hydrogen, $C_{1-5}$ alkyl, $C_{1-5}$ alkoxy or - COOH;
p11 is 0 to 4, p15 is 1 to 2, and p11 + p15 $\leq$ 5;
p21 is 0 to 5;
p41 is 0 to 4, p45 is 1 to 2, and p41 + p45 $\leq$ 5;
$P^{31}$ is $C_{4-20}$ alkyl (where a part or all of the alkyl can form a ring, and a part or all of H in the alkyl can be replaced with halogen);

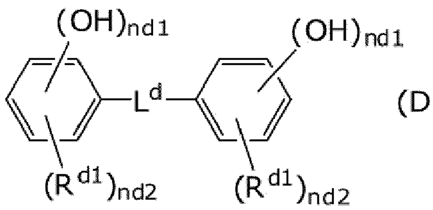
(D-1)

where

nd1 is each independently 1, 2 or 3,
nd2 is each independently 0, 1, 2 or 3,
$R^{d1}$ is each independently $C_{1-7}$ alkyl,
$L^d$ is $C_{1-15}$ divalent alkylene (which can be substituted with an optionally hydroxy-substituted aryl, and which can form a ring with a substituent other than $L^d$).

The method for manufacturing a resist pattern according to the present invention comprises the following steps:

(1) applying the above-described composition above a substrate;
(2) heating the composition to form a resist layer;
(3) exposing the resist layer;
(4) post-exposure baking the resist layer; and
(5) developing the resist layer.

The method for manufacturing a device according to the present invention comprises the method described above.

EFFECTS OF THE INVENTION

According to the present invention, one or more of the following effects can be desired. Sufficient resolution can be obtained. A resist pattern shape suitable for lift-off can be formed. Sensitivity of the resist composition is high. Resist pattern shape of thin film can be formed. Heat resistance of the resist pattern is high. It is possible to precisely control the solubility of the resist film in the exposed area. The dissolution of the soluble area by the developer can be suitably performed. It is possible to control uneven distribution of the photoacid generator and control the pattern shape. It is possible to obtain a resist film and a resist pattern suitable for the lift-off process without essentially containing any dissolution rate modifier, cross-linking agent and/or plasticizer.

BRIEF DESCRIPTION OF THE DRAWINGS

[Figure 1] Schematic sectional views for explaining a resist pattern of reverse tapered shape, a resist pattern of overhanging shape, and a modified example of the resist pattern of overhanging shape.
[Figure 2] Schematic view showing sectional shape of a resist pattern.

DETAILED DESCRIPTION OF THE INVENTION

MODE FOR CARRYING OUT THE INVENTION

Definition

Unless otherwise specified in the present specification, the definitions and examples described in this paragraph are followed.
The singular form includes the plural form and "one" or "that" means "at least one". An element of a concept can be expressed by a plurality of species, and when the amount (for example, mass % or mol %) is described, it means sum of the plurality of species.
"And/or" includes a combination of all elements and also includes single use of the element.
When a numerical range is indicated using "to" or "-", it includes both endpoints and units thereof are common. For example, 5 to 25 mol % means 5 mol % or more and 25 mol % or less.
The descriptions such as "$C_{x-y}$", "$C_x$-$C_y$" and "$C_x$" mean the number of carbons in a molecule or substituent. For example, $C_{1-6}$ alkyl means an alkyl chain having 1 or more and 6 or less carbons (methyl, ethyl, propyl, butyl, pentyl, hexyl etc.).
When polymer has a plural types of repeating units, these repeating units copolymerize. These copolymerization may be any of alternating copolymerization, random copolymerization, block copolymerization, graft copolymerization, or a mixture thereof. When polymer or resin is represented by a structural formula, n, m or the like that is attached next to parentheses indicate the number of repetitions.
Celsius is used as the temperature unit. For example, 20 degrees means 20 degrees Celsius.
The additive refers to a compound itself having a function thereof (for example, in the case of a base generator, a compound itself that generates a base). An embodiment in which the compound is dissolved or dispersed in a solvent and added to a composition is also possible. As one embodiment of the present invention, it is preferable that such a solvent is contained in the composition according to the present invention as the solvent (C) or another component.
Hereinafter, embodiments of the present invention are described in detail.

<Positive type lift-off resist composition>

The positive type lift-off resist composition according to the present invention (hereinafter sometimes referred to as the composition) comprises a polymer (A) having a certain structure, a photoacid generator (B) and a solvent (C).
The composition according to the present invention is preferably a thin film positive type lift-off chemically amplified resist composition.
Here, in the present invention, the thickness of the resist film is preferably 50 to 1,500 nm (more preferably 90 to 1,200 nm; further preferably 90 to 1,100 nm; further more preferably 90 to 950 nm). The thin film means that the formed resist film has a thickness of 1 μm or less.
The viscosity of the composition according to the present invention is preferably 5 to 900 cP (more preferably 7 to 700 cP). The viscosity is measured at 25°C with a capillary viscometer.
The composition according to the present invention is more preferably a thin film KrF positive type lift-off

chemically amplified resist composition.

Polymer (A)

The polymer (A) used in the present invention reacts with an acid to increase the solubility in an alkaline aqueous solution. This kind of polymer has, for example, an acid group protected by a protecting group, and when an acid is added from the outside, the protecting group is eliminated and the solubility in an alkaline aqueous solution increases. The polymer (A) comprises at least one of the repeating units represented by the following (A-1), (A-2), (A-3) or (A-4).

The cLogP of the polymer (A) is 2.76 to 3.35 (preferably 2.77 to 3.12; more preferably 2.78 to 3.00; further more preferably 2.78 to 2.99). The cLogP is a value for calculating the common logarithm LogP of 1-octanol/water partition coefficient P. The cLogP can be calculated by the method described in "Prediction of Hydrophobic (Lipophilic) Properties of Small Organic Molecules" (Arup K. Ghose et al., J. Phys. Chem. A 1998, 102, 3762-3772). In the present specification, using ChemDraw Pro 12.0 of CambridgeSoft, the cLogP of each repeating unit is calculated and the cLogP $\times$ composition ratio of each repeating unit is summed up to calculate the cLogP of the polymer (A). When calculating the cLogP of each repeating unit, assuming that the polymerization is made per each repeating unit, and the calculation is performed without including the ends other than the repeating unit. For example, when the cLogP of repeating units A, B and C of the polymer (A) are respectively 2.88, 3.27 and 2.05, and the composition ratio is 6 : 2 : 2, the cLogP of the polymer (A) is 2.79.

Although not to be bound by theory, it can be thought that the cLogP being within the above range brings about at least one of the above-mentioned effects. For example, the control of solubility in the exposed area becomes accurate. This makes it possible to obtain a polymer having properties useful for positive type lift-off from among many existing polymer.

The formula (A-1) is as follows:

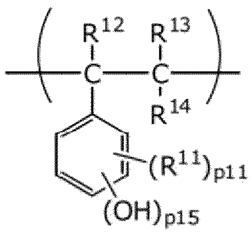

(A-1)

wherein

$R^{11}$ is each independently $C_{1-5}$ alkyl (where $-CH_2-$ in the alkyl can be replaced with -O-);
$R^{12}$, $R^{13}$ and $R^{14}$ are each independently hydrogen, $C_{1-5}$ alkyl, $C_{1-5}$ alkoxy or -COOH; and
p11 is 0 to 4, p15 is 1 to 2, and $p11 + p15 \leq 5$.

In the present invention, the expression "$-CH_2-$(methylene) in the alkyl can be replaced by -O- (oxy)" means that oxy can be present between carbon atoms in the alkyl by replacement. It is not intended that the terminal carbon in the alkyl becomes oxy, i.e., have alkoxy or hydroxy. This is the same hereinafter as well.

$R^{11}$ is preferably methyl or ethyl; more preferably methyl.

$R^{12}$, $R^{13}$ and $R^{14}$ are preferably hydrogen or methyl; more preferably hydrogen.

The polymer (A) can contain a plurality of types of structural units represented by the formula (A-1). For example, it is possible for the polymer to have a structural unit of p15 = 1 and a structural unit of p15 = 2 at a ratio of 1 : 1. In this case, it becomes that p15 = 1.5 as a whole. Hereinafter, unless otherwise specified, the same applies to the numbers for representing resin or polymer in the present invention.

p11 is preferably 0 or 1; more preferably 0.

p15 is preferably 0 or 1; more preferably 1.

An exemplified embodiment of the formula (A-1) includes the following:

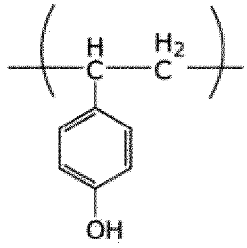

cLogP=2.88

The formula (A-2) is as follows:

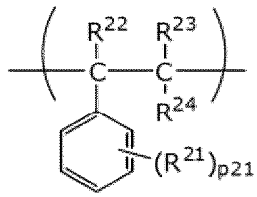

(A-2)

wherein

$R^{21}$ is each independently $C_{1-5}$ alkyl (where $-CH_2-$ in the alkyl can be replaced with -O-);
$R^{22}$, $R^{23}$ and $R^{24}$ are each independently hydrogen, $C_{1-5}$ alkyl, $C_{1-5}$ alkoxy or -COOH; and
p21 is 0 to 5.

$R^{21}$ is preferably methyl, ethyl, t-butyl or t-butoxy; more preferably methyl or ethyl; further preferably methyl.
$R^{22}$, $R^{23}$ and $R^{24}$ are preferably hydrogen or methyl; more preferably hydrogen.
p21 is preferably 0, 1, 2, 3, 4 or 5; more preferably 0 or 1; further preferably 0.
An exemplified embodiment of the formula (A-2) includes the following:

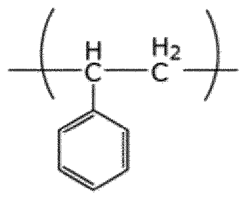

cLogP=3.27

The formula (A-3) is as follows:

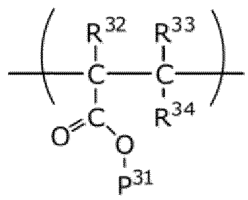

(A-3)

wherein

$R^{32}$, $R^{33}$ and $R^{34}$ are each independently hydrogen, $C_{1-5}$ alkyl, $C_{1-5}$ alkoxy or -COOH; and

$P^{31}$ is $C_{4-20}$ alkyl. A part or all of the alkyl can form a ring, and a part or all of H in the alkyl can be replaced with halogen. The alkyl moiety of $P^{31}$ is preferably branched or cyclic. When the $C_{4-20}$ alkyl in $P^{31}$ is replaced with halogen, it is preferable that all are replaced, and the halogen that replaces is preferably F or Cl; more preferably F. It is a preferred embodiment of the present invention that H of the $C_{4-20}$ alkyl in $P^{31}$ is not replaced with any halogen.

$R^{32}$, $R^{33}$ and $R^{34}$ are preferably hydrogen, methyl, ethyl, t-butyl, methoxy, t-butoxy or -COOH; more preferably hydrogen or methyl; further preferably hydrogen.

$P^{31}$ is preferably methyl, isopropyl, t-butyl, cyclopentyl, methylcyclopentyl, ethylcyclopentyl, cyclohexyl, methylcyclohexyl, ethylcyclohexyl, adamantyl, methyladamantyl or ethyladamantyl; more preferably t-butyl, ethylcyclopentyl, ethylcyclohexyl or ethyladamantyl; further preferably t-butyl, ethylcyclopentyl or ethyladamantyl; further more preferably t-butyl.

Exemplified embodiments of the formula (A-3) include the following:

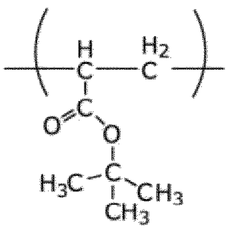
cLogP=2.05

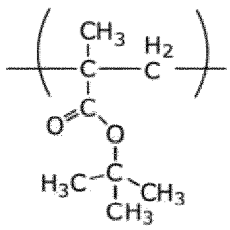
cLogP=2.76

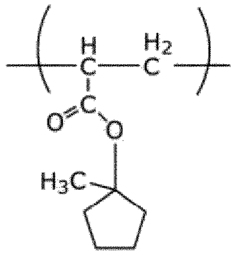
cLogP=2.52

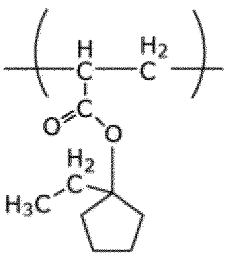
cLogP=3.01

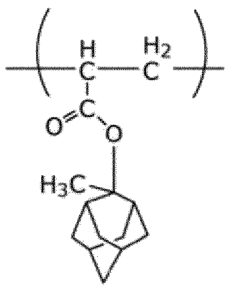
cLogP=3.40

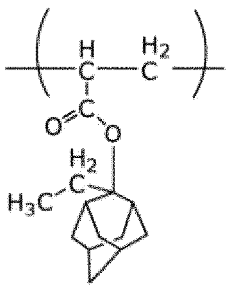
cLogP=3.89

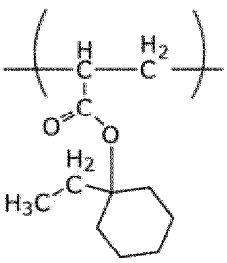
cLogP=3.43

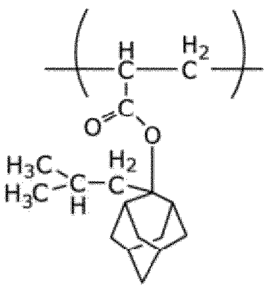
cLogP=4.29

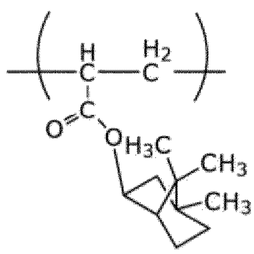
cLogP=3.81

The formula (A-4) is as follows:

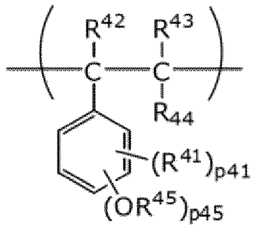

(A-4)

wherein

$R^{41}$ and $R^{45}$ are each independently $C_{1-5}$ alkyl (where $-CH_2-$ in the alkyl can be replaced with -O-);
$R^{42}$, $R^{43}$ and $R^{44}$ are each independently hydrogen, $C_{1-5}$ alkyl, $C_{1-5}$ alkoxy or -COOH; and
p41 is 0 to 4, p45 is 1 to 2, and p41 + p45 $\leq$ 5.

$R^{45}$ is preferably methyl, t-butyl or $-CH(CH_3)-O-CH_2CH_3$ (more preferably methyl).
$R^{41}$ is preferably methyl, ethyl or t-butyl; more preferably methyl.
$R^{42}$, $R^{43}$ and $R^{44}$ are preferably hydrogen or methyl; more preferably hydrogen.
p41 is preferably 0, 1, 2, 3 or 4; more preferably 0 or 1; further preferably 0.
p45 is preferably 1 or 2; more preferably 1.
Exemplified embodiments of the formula (A-4) include the following:

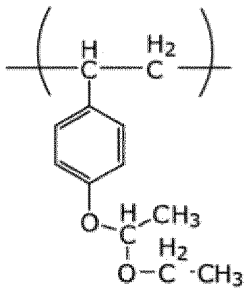

cLogP=3.84

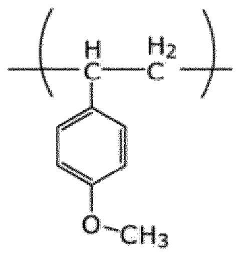

cLogP=3.14

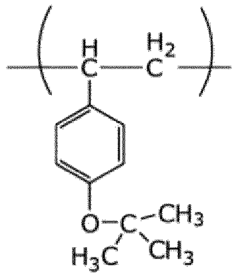

cLogP=4.02

These structural units are appropriately compounded according to the purpose, and their compounding ratio is not particularly limited as long as cLogP satisfies 2.76 to 3.35. It is a preferable embodiment that the compounding is made so that the rate of increase in solubility in the alkaline aqueous solution by an acid becomes appropriate.
$n_{A-1}$, $n_{A-2}$, $n_{A-3}$ and $n_{A-4}$, which are the numbers of repeating units represented by the formulae (A-1), (A-2), (A-3) and (A-4) in the polymer (A), are described below:

$n_{A-1} / (n_{A-1} + n_{A-2} + n_{A-3} + n_{A-4})$ is preferably 40 to 80% (more preferably 50 to 80%; further preferably 55 to 75%; further more preferably 55 to 65%).
$n_{A-2} / (n_{A-1} + n_{A-2} + n_{A-3} + n_{A-4})$ is preferably 0 to 40% (more preferably 5 to 35%; further preferably 5 to 25%; further more preferably 15 to 25%).
$n_{A-3} / (n_{A-1} + n_{A-2} + n_{A-3} + n_{A-4})$ is preferably 0 to 40% (more preferably 10 to 35%; further preferably 15 to 35%; further more preferably 15 to 25%).
$n_{A-4} / (n_{A-1} + n_{A-2} + n_{A-3} + n_{A-4})$ is preferably 0 to 60% (more preferably 10 to 55%; further preferably 20 to 50%; further more preferably 35 to 45%).

A preferred embodiment includes the following:

$$n_{A-1} / (n_{A-1} + n_{A-2} + n_{A-3} + n_{A-4}) = 40 \text{ to } 80\%,$$

$$n_{A-2} / (n_{A-1} + n_{A-2} + n_{A-3} + n_{A-4}) = 0 \text{ to } 40\%,$$

$$n_{A-3} / (n_{A-1} + n_{A-2} + n_{A-3} + n_{A-4}) = 0 \text{ to } 40\%,$$

and

$$n_{A-4} / (n_{A-1} + n_{A-2} + n_{A-3} + n_{A-4}) = 0 \text{ to } 60\%.$$

As one embodiment of the present invention, it is preferable that $(n_{A-3} + n_{A-4}) / (n_{A-1} + n_{A-2} + n_{A-3} + n_{A-4}) > 0\%$ is satisfied. This is because the presence of units such as (A-3) or (A-4) that can be deprotected by an acid makes it possible to increase the solubility of the polymer portion of the resist film in a developer. $n_{A-3} > 0$ and $n_{A-4} = 0$, or $n_{A-3} = 0$ and $n_{A-4} > 0$ is more preferable. As another embodiment, $n_{A-2} > 0$ and $n_{A-3} > 0$, and/or $n_{A-2} = 0$ and $n_{A-4} > 0$ are preferred.

The polymer (A) can also contain repeating units other than the repeating units represented by (A-1), (A-2), (A-3) and (A-4). $n_{total}$, which is the number of all repeating units contained in the polymer (A) preferably satisfy the following: $(n_{A-1} + n_{A-2} + n_{A-3} + n_{A-4}) / n_{total}$ is 80 to 100% (more preferably 90 to 100%; further preferably 95 to 100%; further more preferably 100%).

It is also a preferable embodiment of the present invention that any structural units other than the repeating units represented by (A-1), (A-2), (A-3) and (A-4) are not contained.

Exemplified embodiments of the polymer (A) include the following:

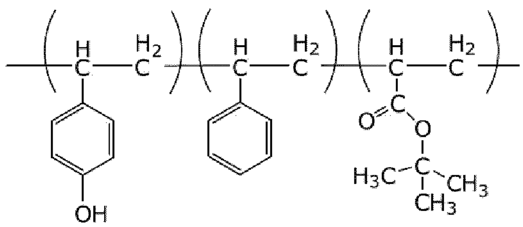

6 : 2 : 2 cLogP=2.79

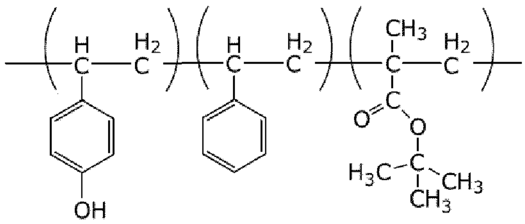

6 : 2 : 2 cLogP=2.93
6 : 1 : 3 cLogP=2.81

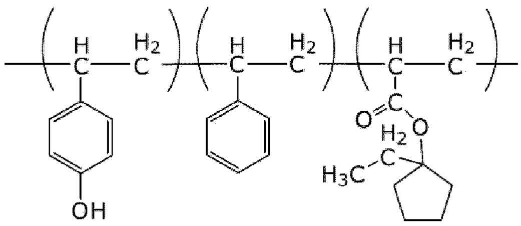

6 : 2 : 2 cLogP=2.98
6 : 1 : 3 cLogP=2.96

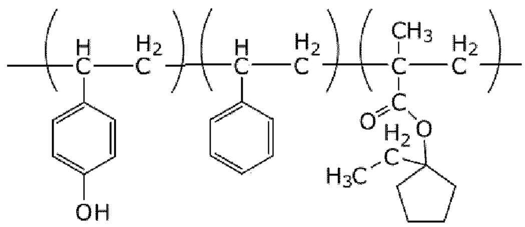

6 : 2 : 2 cLogP=3.13
6 : 1 : 3 cLogP=3.10

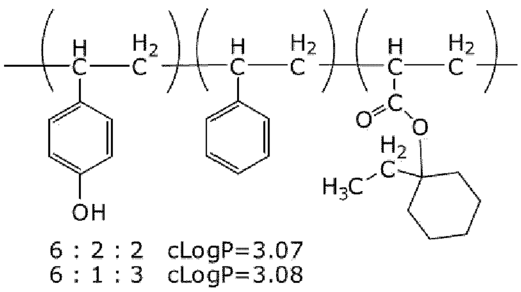

6 : 2 : 2 cLogP=3.07
6 : 1 : 3 cLogP=3.08

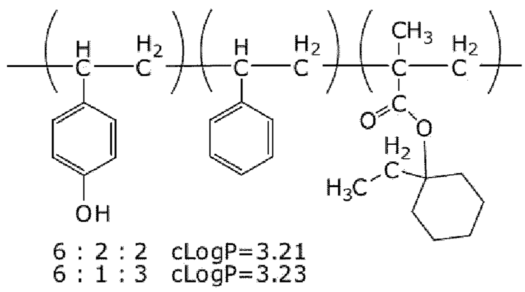

6 : 2 : 2 cLogP=3.21
6 : 1 : 3 cLogP=3.23

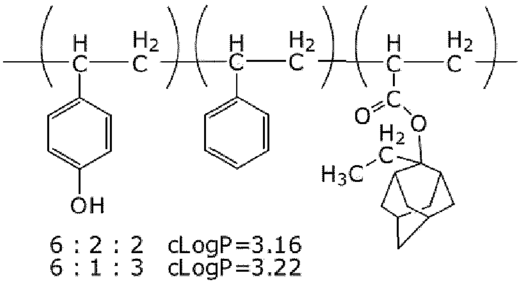

6 : 2 : 2 cLogP=3.16
6 : 1 : 3 cLogP=3.22

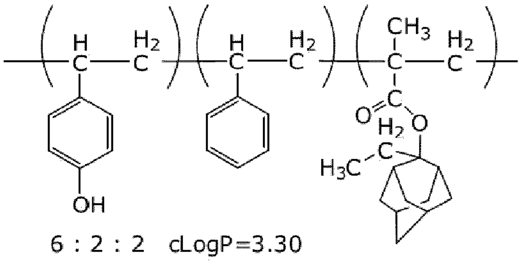

6 : 2 : 2 cLogP=3.30

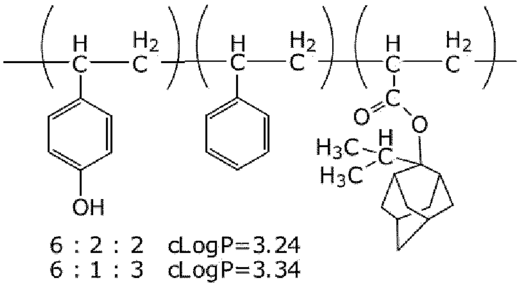

6 : 2 : 2 cLogP=3.24
6 : 1 : 3 cLogP=3.34

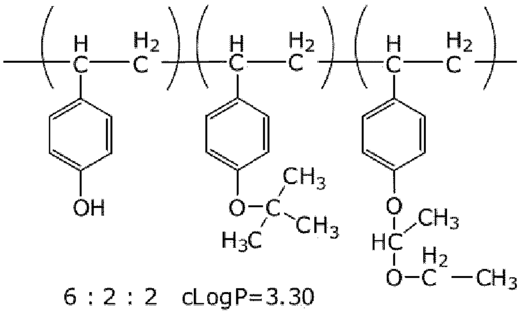

6 : 2 : 2 cLogP=3.30

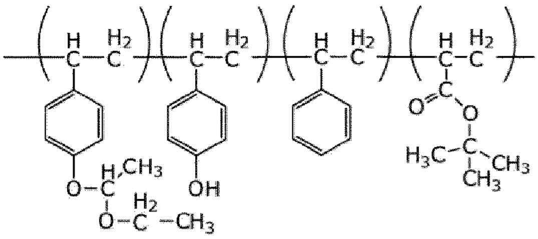

1 : 6 : 2 : 1 cLogP=2.97

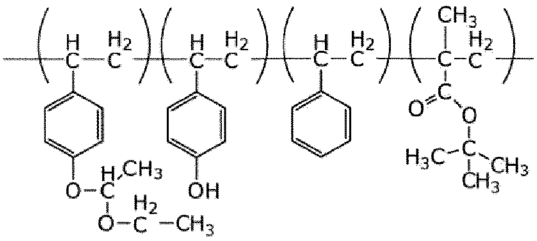

1 : 6 : 2 : 1 cLogP=3.11

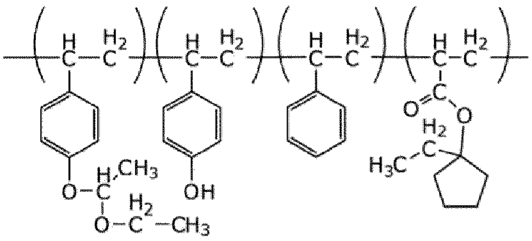

1 : 6 : 2 : 1 cLogP=3.07

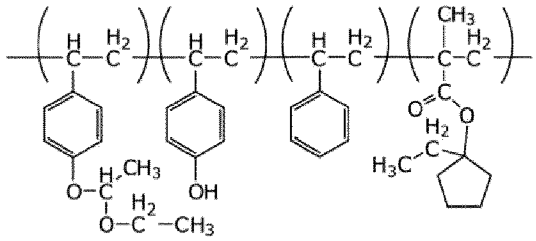

1 : 6 : 2 : 1 cLogP=3.21

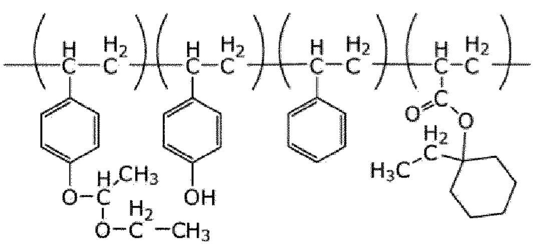

1 : 6 : 2 : 1 cLogP=3.12

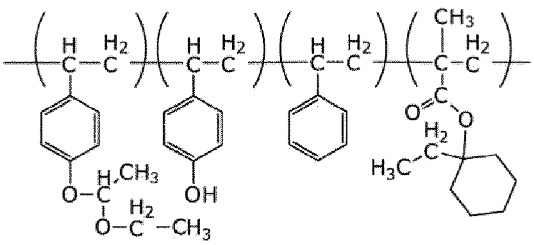

1 : 6 : 2 : 1 cLogP=3.25

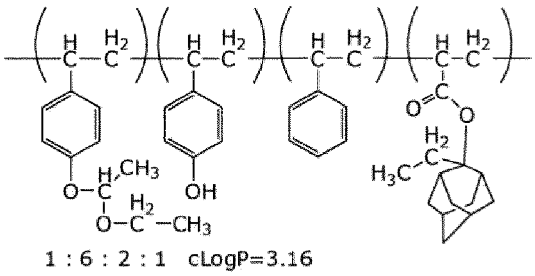

1 : 6 : 2 : 1 cLogP=3.16

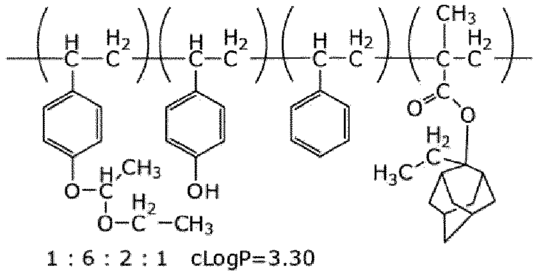

1 : 6 : 2 : 1 cLogP=3.30

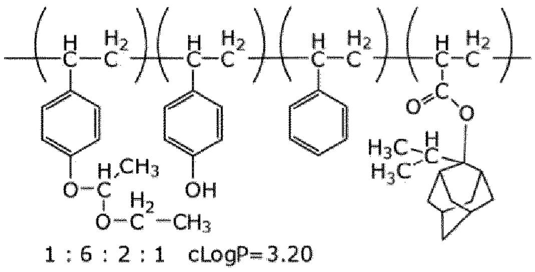

1 : 6 : 2 : 1 cLogP=3.20

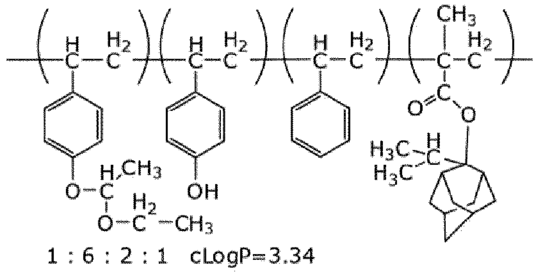

1 : 6 : 2 : 1 cLogP=3.34

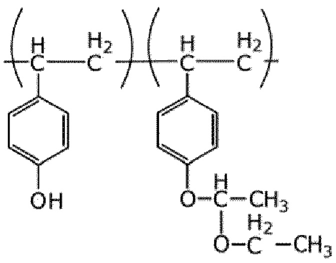

65 : 35 cLogP=3.22

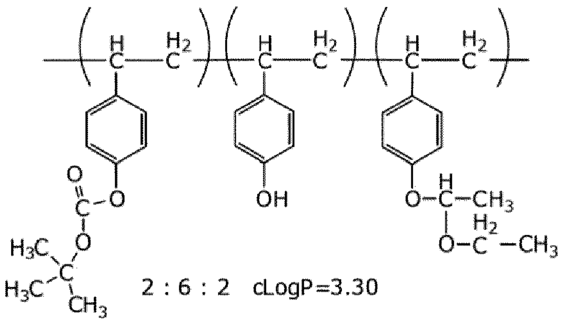

2 : 6 : 2 cLogP=3.30

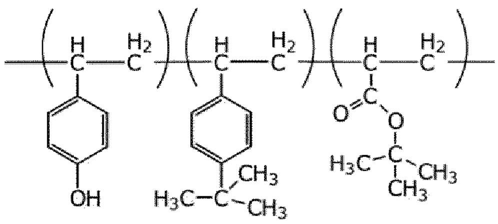

6 : 2 : 2 cLogP=3.13

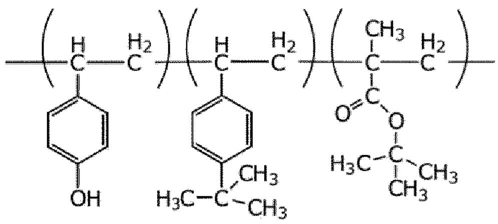

6 : 2 : 2 cLogP=3.27

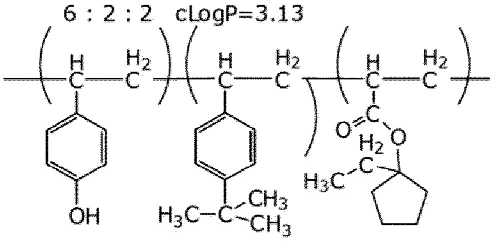

6 : 2 : 2 cLogP=3.32

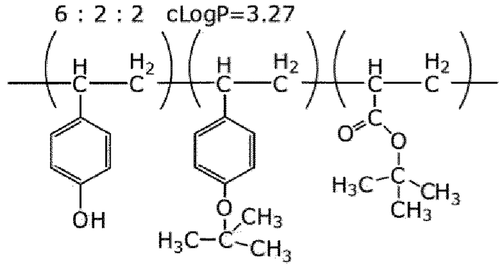

6 : 2 : 2 cLogP=2.94

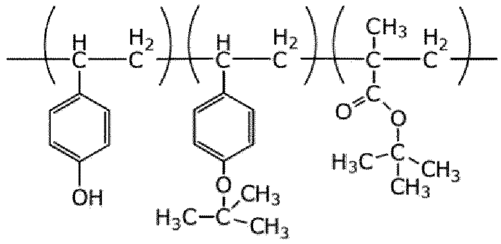

6 : 2 : 2 cLogP=3.08

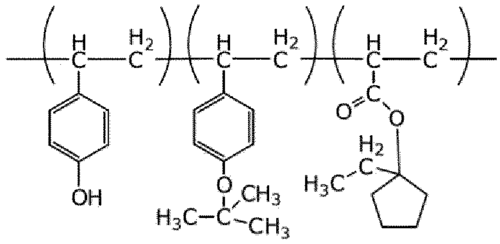

6 : 2 : 2 cLogP=3.13

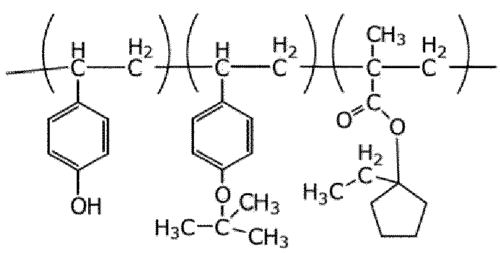

6 : 2 : 2 cLoqP=3.28

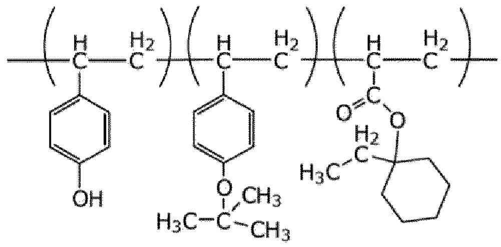

6 : 2 : 2 cLogP=3.22

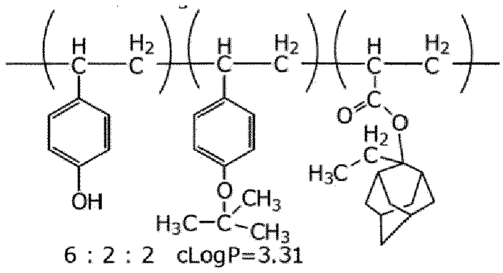

6 : 2 : 2 cLogP=3.31

The following polymer (A) has the repeating units (A-1), (A-2) and (A-3). After forming a resist film from the composition of the present invention, it receives an acid from the photoacid generator (B) by exposure, and the protecting group of the unit (A-3) is released in the polymer (A). The cLogP of the corresponding unit (A-3) portion changes from 2.05 to 0.91. As a result, the cLogP of the resist film that is the acid-accepting portion changes from 2.79 to 2.56 for the entire polymer (A) (Δ0.23).

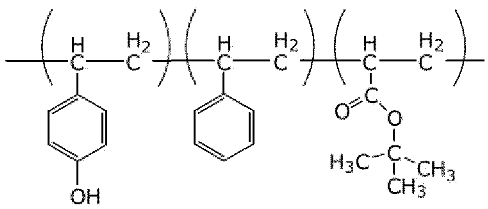

6 : 2 : 2 cLogP=2.79

The following polymer (A) has the repeating units (A-1), (A-2) and (A-3). After forming a resist film from the composition of the present invention, it receives an acid from the photoacid generator (B) by exposure, and the protecting group of the unit (A-3) is released in the polymer (A). The cLogP of the corresponding unit (A-3) portion changes from 3.01 to 0.91. As a result, the cLogP of the resist film that is the acid-accepting portion changes from 2.98 to 2.56 for the entire polymer (A) (Δ0.42).

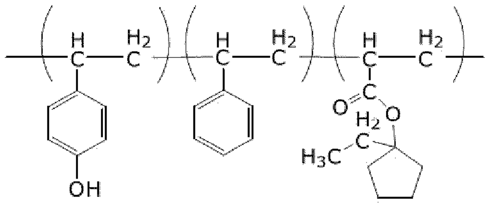

6 : 2 : 2 cLogP=2.98

The following polymer (A) has the repeating units (A-1) and two types of (A-4). After forming a resist film from the composition of the present invention, it receives an acid from the photoacid generator (B) by exposure, and the protecting groups of the units (A-4) described on the right are released in the polymer (A). The cLogP of the corresponding units (A-4) portion changes from 3.84 to 2.88. As a result, cLogP of the resist film that is the acid-accepting portion changes from 3.30 to 3.11 for the entire polymer (A) (Δ0.19).

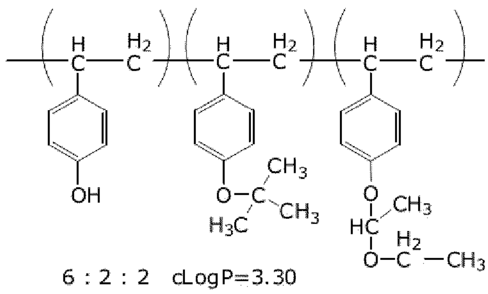

6 : 2 : 2 cLogP=3.30

As an embodiment of the present invention, the amount of decrease in the cLogP of the entire polymer (A) before and after exposure is preferably 0.15 to 0.55 (more preferably 0.18 to 0.50; further preferably 0.19-0.45). Although not to be bound by theory, it can be thought that the cLogP of the resist film in the exposed area is reduced within the above range, so that the dissolution of the exposed area by the developer can be suitably promoted.

In Comparative Composition 1 described later, the following polymer A1 and polymer G are used at a mass ratio of 1 : 1. The cLogPs are 2.79 and 3.21, respectively, giving an average cLogP of 3.00. After forming a resist film from Comparative Example Composition 1, it receives an acid from the photoacid generator (B) by exposure, and the protecting group of the unit (A-3) is released in the polymer A1. As described above, the cLogP of the polymer A1 portion changes from 2.79 to 2.56. On the other hand, since the polymer G, which is a novolac resin, is not deprotected, the cLogP remains 3.21. Therefore, the average cLogP of the polymer A1 and the polymer G after exposure is 2.89 (Δ0.11).

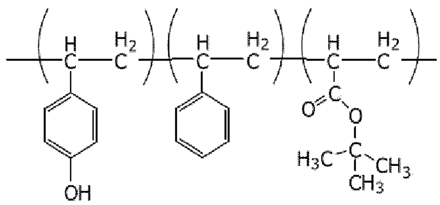

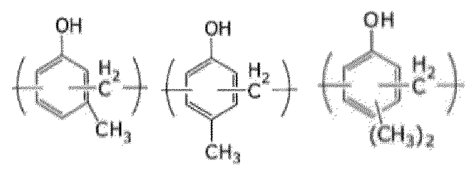

6 : 2 : 2 cLogP=2.79

The mass average molecular weight (hereinafter sometimes referred to as Mw) of the polymer (A) is preferably 1,000 to 50,000 (more preferably 2,000 to 30,000; further preferably 5,000 to 20,000; further more preferably 8,000 to 15,000).

The number average molecular weight (hereinafter sometimes referred to as Mn) of the polymer (A) is preferably 1,000 to 50,000 (more preferably 2,000 to 30,000).

In the present invention, Mw and Mn can be measured by gel permeation chromatography (GPC). In the measurement, it is preferable example that a GPC column at 40 degrees Celsius, an elution solvent of tetrahydrofuran at 0.6 mL/min and monodisperse polystyrene as a standard are used.

The following is described for explanation. In the composition of the present invention, these polymer (A) can be used in any combination of any of two or more as long as they are represented by the above formula. For example, a composition containing both the following two types of polymer (A) is also one embodiment of the present invention:

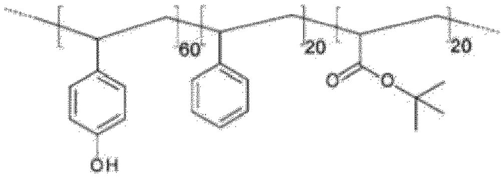
,
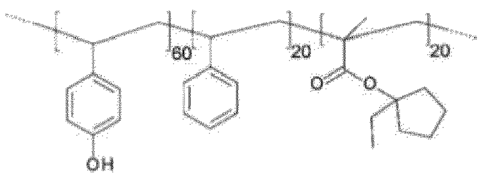

The same applies to the composition of the present invention in the following description unless otherwise specified.

Preferably, the polymer (A) contained in the composition according to the present invention consists of one or two types of polymer; more preferably, the polymer (A) consists of one type of polymer. Variations in Mw distribution and polymerization are allowed.

The content of the polymer (A) is preferably 1 to 20 mass % (more preferably 5 to 19 mass %; further preferably 10 to 18 mass %; further more preferably 14 to 18 mass %) based on the composition.

Photoacid generator (B)

The composition according to the present invention comprises a photoacid generator (B). The photoacid generator (B) releases an acid upon irradiation with light. Preferably, the acid derived from the photoacid generator (B) acts on the polymer (A) to increase the solubility of the polymer (A) in an alkaline aqueous solution. For example, when the polymer (A) has an acid group protected by a protecting group, the protecting group is released by an acid. The photoacid generator (B) used in the composition according to the present invention can be selected from those conventionally known.

The photoacid generator (B) releases an acid upon exposure. The acid dissociation constant pKa ($H_2O$) of the acid is -20 to 1.4 (more preferably -16 to 1.4; further preferably - 16 to 1.2; furhter more preferably -16 to 1.1).

The photoacid generator (B) is preferably represented by the following formula (B-1) or comprises a structure of the formula (B-2). More preferably, the photoacid generator (B) is represented by the formula (B-1).

The formula (B-1) is as follows:

$B^{n+}$cation $B^{n-}$anion (B-1)

wherein

the $B^{n+}$cation is a cation represented by the formula (BC1), a cation represented by the formula (BC2), a cation represented by the formula (BC3) or a cation represented by the formula (BC4) (preferably the cation represented by the formula (BC1) or the cation represented by the formula (BC2); more preferably the cation represented by the formula (BC1)). The $B^{n+}$cation is n valent as a whole, and n is 1 to 3.

The $B^{n-}$anion is an anion represented by the formula (BA1), an anion represented by the formula (BA2), an anion represented by the formula (BA3), an anion represented by the formula (BA4) or an anion represented by the formula (BA5) (preferably an anion represented by the formula (BA1) or an anion represented by the formula (BA5); more preferably an anion represented by the formula (BA5)). The $B^{n-}$anion is a sulfonate anion. The $B^{n-}$anion is n valent as a whole.

n is preferably 1 or 2; more preferably 1.

Although not to be bound by theory, using the photoacid generator (B) as described above, it can be thought possible to control so that a large amount of the photoacid generator (B) is present near the bottom face when the resist film is formed and to control the shape of the pattern to be an reverse tapered shape. In a positive type resist, the exposed area is solubilized, but the amount of light decreases while reaching the bottom face of the resist film, so it is effective to control the pattern shape by the amount of the photoacid generator (B) present.

The formula (BC1) is as follows:

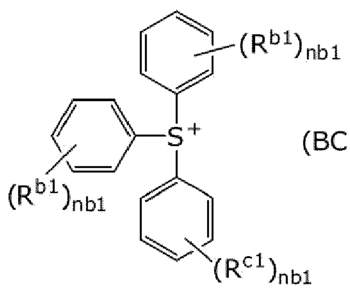

(BC1)

wherein

$R^{b1}$ is each independently $C_{1-6}$ alkyl, $C_{1-6}$ alkoxy, $C_{6-12}$ aryl, $C_{6-12}$ arylthio or $C_{6-12}$ aryloxy, and
nb1 is each independently 0, 1, 2 or 3.

$R^{b1}$ is preferably methyl, ethyl, t-butyl, methoxy, ethoxy, phenylthio or phenyloxy (more preferably t-butyl, methoxy, ethoxy, phenylthio or phenyloxy).
It is also a preferable embodiment that all of nb1 are 1 and all of $R^{b1}$ are identical. Further, it is also a preferable embodiment that all of nb1 are 0.
Exemplified embodiments of the formula (BC1) include the following:

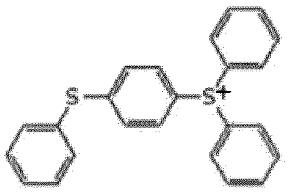
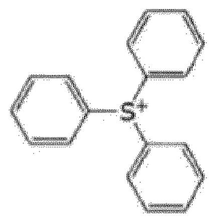
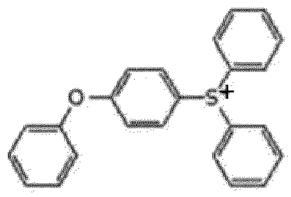
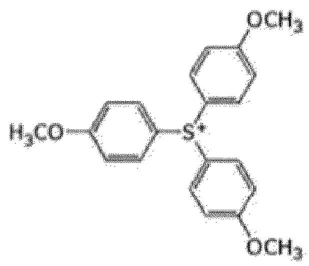
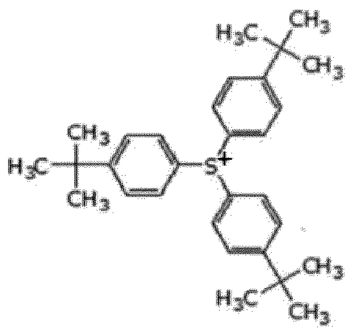

The formula (BC2) is as follows:

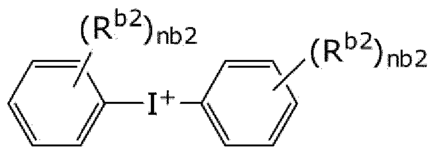
(BC2)

wherein

$R^{b2}$ is each independently $C_{1-6}$ alkyl, $C_{1-6}$ alkoxy or $C_{6-12}$ aryl, and
nb2 is each independently 0, 1, 2 or 3.

$R^{b2}$ is preferably alkyl having a $C_{4-6}$ branched structure. Each $R^{b2}$ in the formula can be identical to or different from each other, and one in which they are identical to each other is more preferable. $R^{b2}$ is further preferably t-butyl or 1,1-dimethylpropyl (further more preferably t-butyl).
It is preferable that nb2 is 1 each.
Exemplified embodiments of the formula (BC2) include the following:

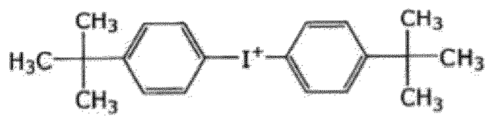

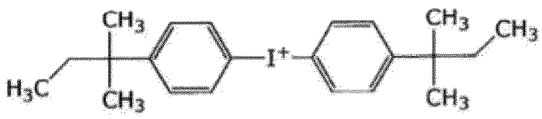

The formula (BC3) is as follows:

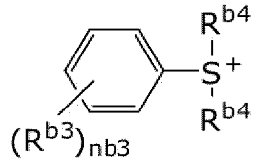

(BC3)

wherein

$R^{b3}$ is each independently $C_{1-6}$ alkyl, $C_{1-6}$ alkoxy or $C_{6-12}$ aryl,
$R^{b4}$ is each independently $C_{1-6}$ alkyl, and
nb3 is each independently 0, 1, 2 or 3.

$R^{b3}$ is preferably each independently methyl, ethyl, methoxy or ethoxy (more preferably each independently methyl or methoxy).
$R^{b4}$ is preferably methyl or ethyl (more preferably methyl). nb3 is preferably 1, 2 or 3 (more preferably 3).
An exemplified embodiment of the formula (BC3) includes the following:

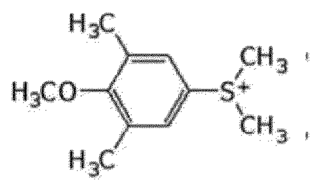

The formula (BC4) is as follows:

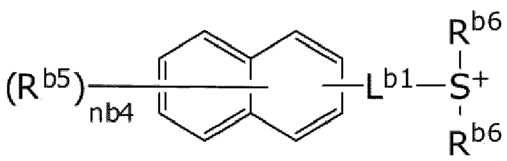

(BC4)

wherein

$L^{b1}$ is a single bond or $C_{1-3}$ divalent alkylene, and methylene in the alkylene can be replaced with carbonyl,
$R^{b5}$ is each independently $C_{1-6}$ alkyl, $C_{1-6}$ alkoxy or $C_{6-12}$ aryl;
$R^{b6}$ is each independently $C_{1-6}$ alkyl, and
nb4 is each independently 0, 1, 2 or 3.

$L^{b1}$ is preferably a single bond or ethylene replaced with carbonyl.

$R^{b5}$ is preferably $C_{1-6}$ alkyl, $C_{1-6}$ alkoxy (more preferably $C_{3-6}$ alkoxy; further preferably $C_4$ alkoxy; further more preferably n-butoxy),
$R^{b6}$ is preferably $C_{3-6}$ alkyl (more preferably n-butyl), and
nb4 is preferably 0, 1 or 2 (more preferably 0 or 2).

Exemplified embodiments of the formula (BC4) include the following:

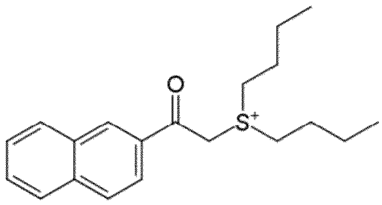

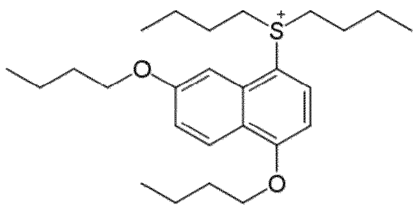

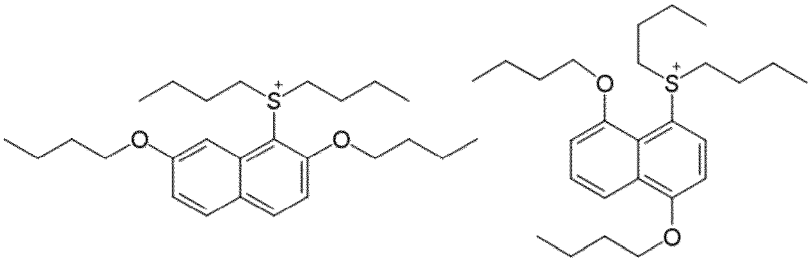

The formula (BA1) is as follows.

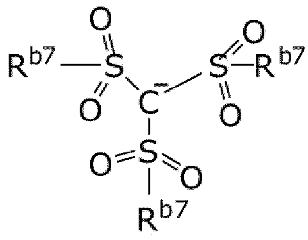

(BA1)

wherein

$R^{b7}$ is each independently fluorine-substituted $C_{1-6}$ alkyl, fluorine-substituted $C_{1-6}$ alkoxy, or $C_{1-6}$ alkyl. For example, $-CF_3$ means that all of hydrogen in methyl ($C_1$) are replaced with fluorine. The above-mentioned fluorine substitution means that a part or all of hydrogen existing in the alkyl moiety are replaced with fluorine, and more preferably all of hydrogen are replaced with fluorine.

The alkyl moiety of $R^{b7}$ is preferably methyl, ethyl or t-butyl (more preferably methyl).

$R^{b7}$ is preferably fluorine-substituted alkyl (more preferably $-CF_3$).

An exemplified embodiment of the formula (BA1) includes the following:

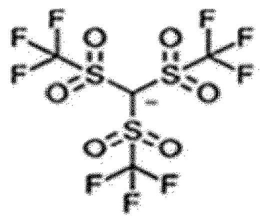

The formula (BA2) is as follows:

$$R^{b8}\text{—}SO_3^- \quad \text{(BA2)}$$

wherein

$R^{b8}$ is fluorine-substituted $C_{1-10}$ alkyl, fluorine-substituted $C_{1-6}$ alkoxy, fluorine-substituted $C_{6-12}$ aryl, fluorine-substituted $C_{2-12}$ acyl or fluorine-substituted $C_{6-12}$ alkoxyaryl. For example, $-CF_3$ means that all of hydrogen in methyl ($C_1$) are replaced with fluorine. The above-mentioned fluorine substitution means that a part or all of hydrogen existing in the alkyl moiety are replaced with fluorine, and more preferably all of hydrogen are replaced with fluorine.

The alkyl moiety of $R^{b8}$ is preferably linear. $R^{b8}$ is preferably fluorine-substituted $C_{1-6}$ alkyl (more preferably fluorine-substituted $C_{2-6}$ alkyl).

The alkyl moiety of $R^{b8}$ is preferably methyl, ethyl, propyl, butyl or pentyl (more preferably propyl, butyl or pentyl;

further preferably butyl; further more preferably n-butyl). The alkyl moiety of $R^{b8}$ is preferably linear.

Exemplified embodiments of the formula (BA2) include the following:

$C_4F_9SO_3$-, $C_3F_7SO_3$-

The formula (BA3) is as follows:

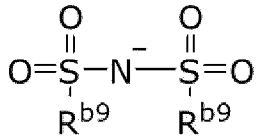 (BA3)

wherein

$R^{b9}$ is each independently fluorine-substituted $C_{1-6}$ alkyl, fluorine-substituted $C_{1-6}$ alkoxy, fluorine-substituted $C_{6-12}$ aryl, fluorine-substituted $C_{2-12}$ acyl or fluorine-substituted $C_{6-12}$ alkoxyaryl, and preferably fluorine-substituted $C_{2-6}$ alkyl. The above-mentioned fluorine substitution means that a part or all of hydrogen existing in the alkyl moiety are replaced with fluorine, and more preferably all of hydrogen are replaced with fluorine.

Two $R^{b9}$ can be bonded to each other to form a fluorine-substituted heterocyclic structure. The heterocyclic ring structure is preferably a saturated ring. The heterocyclic ring structure, including N and S, is preferably a 5- to 8-membered monocyclic ring structure; more preferably a 5- or 6-membered ring; further preferably a 6-membered ring.

The alkyl moiety of $R^{b9}$ is preferably methyl, ethyl, propyl, butyl or pentyl (more preferably methyl, ethyl or butyl; further preferably butyl). It is preferred that the alkyl portion of $R^{b9}$ is linear.

Exemplified embodiments of the formura (BA3) include the following:

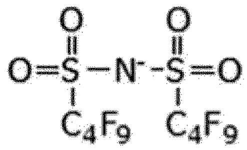

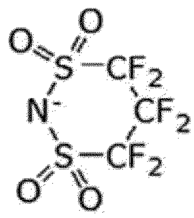

The formula (BA4) is as follows:

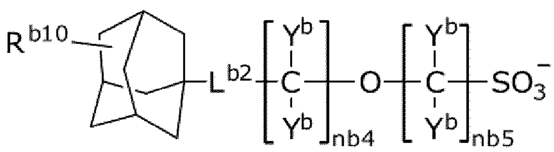 (BA4)

wherein

$R^{b10}$ is hydrogen, $C_{1-6}$ alkyl, $C_{1-6}$ alkoxy or hydroxy,
$L^{b2}$ is carbonyl, oxy or carbonyloxy,
$Y^b$ is each independently hydrogen or fluorine,
nb4 is an integer of 0 to 10, and
nb5 is an integer of 0 to 21.

$R^{b10}$ is preferably hydrogen, methyl, ethyl, methoxy or hydroxy (more preferably hydrogen or hydroxy).

$L^{b2}$ is preferably carbonyl or carbonyloxy (more preferably carbonyl).

Preferably, at least one or more of $Y^b$ is fluorine.

nb4 is preferably 0.

nb5 is preferably 4, 5 or 6.

Exemplified embodiments of the formula (BA4) include the following:

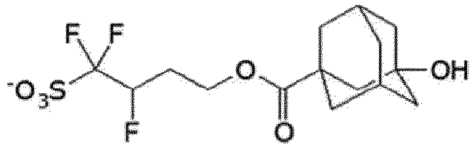
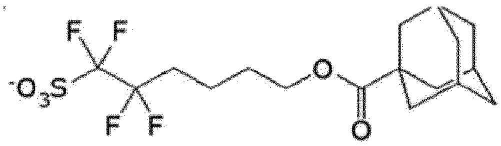

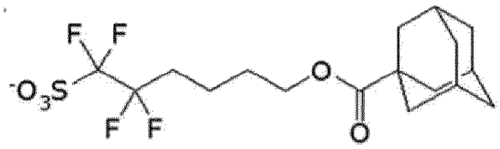

The formula (BA5) is as follows:

$$X^{b}—L^{b3}-SO_3^{-} \qquad (BA5)$$

wherein

$L^{b3}$ is a single bond or $C_{1-3}$ divalent alkylene,
$X^b$ is an aromatic ring, a heteroaromatic ring, or an alicyclic ring, which ring can be substituted by one or more nitro, $C_{1-10}$ alkyl or fluorine-substituted $C_{1-6}$ alkyl, and a ring atom in the alicyclic ring can be replaced by carbonyl.

$L^{b3}$ is preferably a single bond, methylene or ethylene (more preferably a single bond).

$X^b$ is preferably a benzene ring or pyridine ring optionally substituted by methyl or nitro (more preferably a methyl-substituted benzene ring).

Exemplified embodiments of the (BA5) include the following:

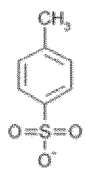
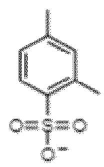
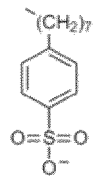
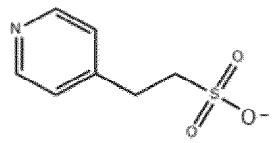

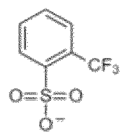
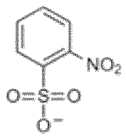
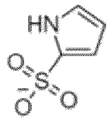
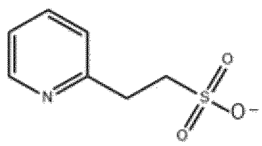

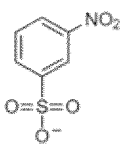
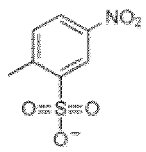
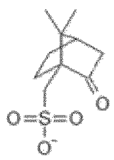
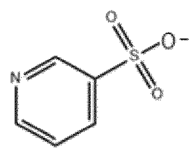

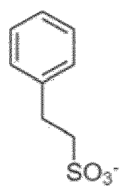
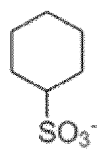

The formula (B-2) is as follows, and is preferably a nonionic type photoacid generator containing this structure.

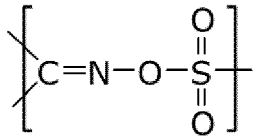 (B-2)

Exemplified embodiments of the compounds containg the formula (B-2) include the following:

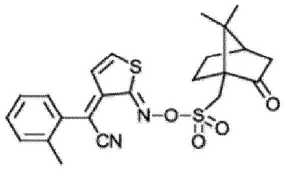

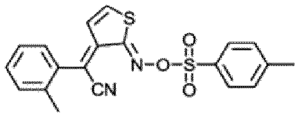

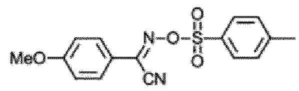

The molecular weight of the photoacid generator (B) is preferably 400 to 2,500 (more preferably 400 to 1,500).
The content of the photoacid generator (B) is preferably 0.05 to 10 mass % (more preferably 0.10 to 2 mass %; further preferably 0.2 to 1 mass %; further more preferably 0.40 to 0.80 mass %) based on the composition.
The content of the photoacid generator (B) is preferably 0.1 to 20 mass % (more preferably 0.5 to 10 mass %; further preferably 1.0 to 5.0 mass %; further more preferably 2.0 to 4.5 mass %) based on the polymer (A).

Solvent (C)

The composition according to the present invention comprises a solvent (C). The solvent is not particularly limited as long as it can dissolve each component to be compounded. The solvent (C) is preferably water, a hydrocarbon solvent, an ether solvent, an ester solvent, an alcohol solvent, a ketone solvent, or any combination of any of these.
Exemplified embodiments of the solvent include water, n-pentane, i-pentane, n-hexane, i-hexane, n-heptane, i-heptane, 2,2,4-trimethylpentane, n-octane, i-octane, cyclohexane, methylcyclohexane, benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, n-amylnaphthalene, trimethylbenzene, methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, sec-heptanol, heptanol-3, n-octanol, 2-ethylhexanol, sec-octanol, n-nonyl alcohol, 2,6-dimethylheptanol-4, n-decanol, sec-undecyl alcohol, trimethyl nonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethyl carbinol, diacetone alcohol, cresol, ethylene glycol, propylene glycol, 1,3-butylene glycol, pentanediol-2,4, 2-methylpentanediol-2,4, hexanediol-2,5, heptanediol-2,4, 2-ethylhexanediol-1,3, diethylene glycol, dipropylene glycol, triethylene glycol, tripropylene glycol, glycerin, acetone, methyl ethyl ketone, methyl n-propyl ketone, methyl n-butyl ketone, diethyl ketone, methyl i-butyl ketone, methyl n-pentyl ketone, ethyl n-butyl ketone, methyl n-hexyl ketone, di-i-butyl ketone, trimethylnonane, cyclohexanone, cyclopentanone, methylcyclohexanone, 2,4-pentanedione, acetonylacetone, diacetone alcohol, acetophenone, fenthion, ethyl ether, i-propyl ether, n-butyl ether (di-n-butyl ether, DBE), n-hexyl ether, 2-ethylhexyl ether, ethylene oxide, 1,2-propylene oxide, dioxolane, 4-methyl dioxolane, dioxane, dimethyl dioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethyl butyl ether, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxytriglycol, tetraethylene glycol di-n-butyl ether, propylene glycol monomethyl ether (PGME), propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, 2-methyltetrahydrofuran, diethyl carbonate, methyl acetate, ethyl acetate, γ-butyrolactone, γ-valerolactone, n-propyl acetate, i-propyl acetate, n-butyl acetate (normal butyl acetate, nBA), i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methyl cyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethyl propionate, n-butyl propionate, i-amyl propionate, diethyl oxalate, di-n-butyl oxalate, methyl lactate, ethyl lactate (EL), n-butyl lactate, n-amyl lactate, diethyl malonate, dimethyl phthalate, diethyl phthalate, propylene glycol

1-monomethyl ether 2-acetate (PGMEA), propylene glycol monoethyl ether acetate, propylene glycol monopropyl ether acetate, N-methylformamide, N,N-dimethylformamide, N,N-diethylformamide, acetamide, N-methylacetamide, N,N-dimethylacetamide, N-methylpropionamide, N-methyl pyrrolidone, dimethyl sulfide, diethyl sulfide, thiophene, tetrahydrothiophene, dimethyl sulfoxide, sulfolane, and 1,3-propane sultone. These solvents can be used alone or in combination of any two or more of these.

The solvent (C)) is preferably PGME, PGMEA, EL, nBA, DBE or any mixture of any of these (more preferably PGME, PGMEA, nBA, DBE or any mixture of any of these; further preferably PGME, PGMEA or any mixture of any of these; further more preferably a mixture of PGME and PGMEA). When two types are mixed, the mass ratio of the first solvent to the second solvent is preferably 95 : 5 to 5 : 95 (more preferably 90 : 10 to 10 : 90; further preferably 80 : 20 to 20 : 80). When three types are mixed, the mass ratio of the first solvent to the sum of the three types is 30 to 90% (more preferably 50 to 80%; further preferably 60 to 70%), the mass ratio of the second solvent to the sum of the three types is 10 to 50% (more preferably 20 to 40%), and the mass ratio of the third solvent to the sum of the three types is 5 to 40% (more preferably 5 to 20%; further preferably 5 to 15%).

In relation to other layers or films, it is also one embodiment that the solvent (C) substantially contains no water. For example, the amount of water in the total solvent (C) is preferably 0.1 mass % or less (more preferably 0.01 mass % or less; further preferably 0.001 mass % or less). It is also a preferable embodiment that the solvent (C) contains no water (0 mass %).

The content of the solvent (C) is preferably 80 to 98.95 mass % (more preferably 80 to 95 mass %; further preferably 80 to 90 mass %) based on the composition. By increasing or decreasing the amount of the solvent occupying in the entire composition, the film thickness after film formation can be controlled.

Dissolution rate modifier (D)

The composition according to the present invention can contain a small amount of dissolution rate modifier (D) represented by the formula (D-1). The dissolution rate modifier has the function of adjusting the solubility of a polymer in a developer. Although not to be bound by theory, the composition according to the present invention can, even if it contains little dissolution rate modifier, obtain resolution suitable for lift-off or form a pattern shape. It is not essential that the composition of the present invention contain any dissolution rate modifier.

The formula (D-1) is as follows:

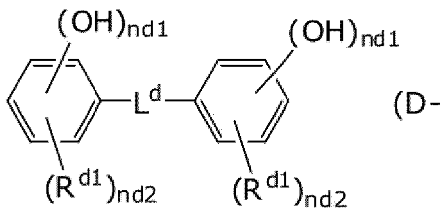

(D-1)

wherein

nd1 is each independently 1, 2 or 3 (preferably 1 or 2; more preferably 1).
nd2 is each independently 0, 1, 2 or 3 (preferably 0, 2 or 3). $R^{d1}$ is each independently $C_{1-7}$ alkyl (preferably methyl, ethyl or cyclohexyl; more preferably methyl or cyclohexyl).
$L^d$ is $C_{1-15}$ divalent alkylene (which can be substituted with an optionally hydroxy-substituted aryl, and which can form a ring with a substituent other than $L^d$) (preferably $C_{2-12}$ divalent alkylene; more preferably $C_{2-7}$ divalent alkylene).

Exemplified embodiments of the dissolution rate modifier (D) are as follows:

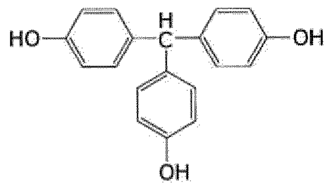

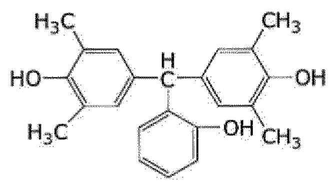

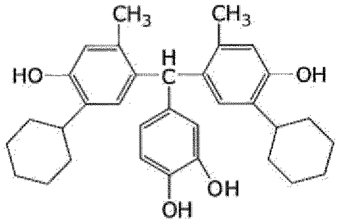
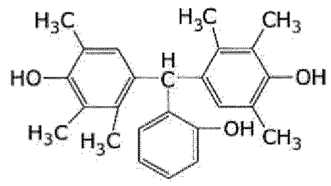
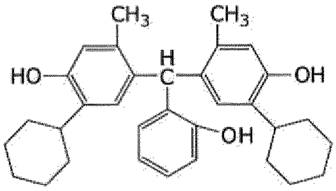
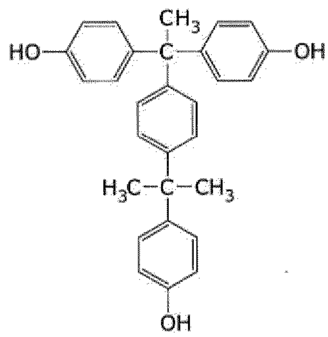
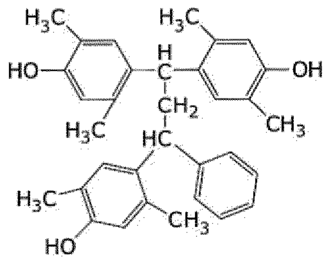
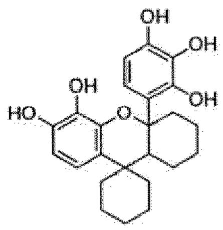
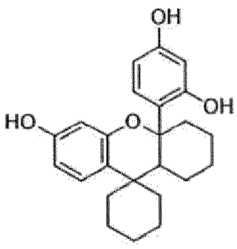

The content of the dissolution rate modifier (D) is 0 to 1.0 mass parts (preferably 0 to 0.1 mass %; further preferably 0 to 0.01 mass %; further more preferably 0.00 mass %) with respect to 100 mass parts of the polymer (A). It is a preferable embodiment of the present invention to contain no dissolution rate modifier (D).

Basic compound (E)

The composition according to the present invention can further comprise a basic compound (E). The basic compound has an effect of suppressing the diffusion of the acid generated in the exposed area and an effect of suppressing the inactivation of the acid on the surface of the resist film by the amine component contained in the air.

The basic compound (E) preferably includes $C_{1-16}$ primary aliphatic amine compound, $C_{2-32}$ secondary aliphatic amine compound, $C_{3-48}$ tertiary aliphatic amine compound, $C_{6-30}$ aromatic amine compound or $C_{5-30}$ heterocyclic amine compound.

Exemplified embodiments of the basic compound (E) include ethylamine, n-octylamine, n-heptylamine, ethylenediamine, triethylamine, tri-n-octylamine, diethylamine, triethanolamine, tris[2-(2-methoxy-ethoxy)ethyl amine, 1,8-diazabicyclo[5.4.0]-undecene-7, 1,5-diazabicyclo[4.3.0]nonen-5, 7-methyl-1,5,7-triazabicyclo[4.4.0]deca-5-ene and 1,5,7-triaza-bicyclo[4.4.0]deca-5-ene.

The base dissociation constant pKb ($H_2O$) of the basic compound (E) is preferably -12 to 5 (more preferably 1 to 4).

The molecular weight of the basic compound (E) is preferably 20 to 500 (more preferably 60 to 400).

The content of the basic compound (E) is preferably 0 to 1 mass % (more preferably 0.01 to 0.5 mass %; further preferably 0.02 to 0.1 mass %) based on the composition. It is a preferred embodiment to contain no basic compound (E).

The content of the basic compound (E) is preferably 0.1 to 20 mass % (more preferably 0.1 to 5 mass %; further preferably 0.1 to 1.0 mass %; further more preferably 0.1 to 0.5 mass %) based on the polymer (A).

Surfactant (F)

The composition according to the present invention can further comprise a surfactant (F). The coatability can be improved by making a surfactant be comprised in it. Examples of the surfactant that can be used in the present invention include (I) anionic surfactants, (II) cationic surfactants or (III) nonionic surfactants, and more particularly (I) alkyl sulfonate, alkyl benzene sulfonic acid and alkyl benzene sulfonate, (II) lauryl pyridinium chloride and lauryl methyl ammonium chloride and (III) polyoxyethylene octyl ether, polyoxyethylene lauryl ether, polyoxyethylene acetylenic glycol ether, fluorine-containing surfactants (for example, Fluorad (3M), Megaface (DIC) and Surflon (AGC)), and organic siloxane surfactants (for example, KF-53 and KP341 (Shin-Etsu Chemical)).
These surfactants can be used alone or in combination of any two or more of these. The content of the surfactant (F) is preferably 0 to 3 mass % (more preferably 0.005 to 0.5 mass %; further preferably 0.01 to 0.2 mass %) based on the composition.
The content of the surfactant (F) is preferably 0.01 to 5 mass % (more preferably 0.01 to 1 mass %; further preferably 0.05 to 0.5 mass %) based on the polymer (A).

Polymer (G)

The composition according to the present invention can further comprise a polymer (G), which is different from the polymer (A). The polymer (G) is different from the polymer (A). Examples of the polymer (G) include novolac polymer, which is obtained, for example, by condensation reaction of phenols and formaldehyde. The cLogP of the polymer (G) is preferably 2.76 to 3.35 (more preferably 3.00 to 3.30; further preferably 3.15 to 3.25).
Preferably, the total mass Ma of the polymer (A) and the total mass Mg of the polymer (G) in the composition satisfy the following:

Ma / (Ma + Mg) is preferably larger than 0 and 100% or less (more preferably 50 to 100%; further preferably 80 to 100%; further more preferably 95 to 100%).
Mg / (Ma + Mg) is preferably 0 to less than 70% (more preferably 0 to 50%; further preferably 0 to 20%; further more preferably 0 to 5%).

It is preferable that the following are satisfied at the same time:

$$0 < Ma / (Ma + Mg) \leq 100\%, \text{ and } 0 \leq Mg / (Ma + Mg) < 70\%.$$

Mg / (Ma + Mg) = 0.0% is also a preferred embodiment of the present invention.
The content of the polymer (G) is preferably 0 to 10 mass % (more preferably 0 to 5 mass %; further preferably 0 to 1 mass %) based on the composition. It is a preferred embodiment of the present invention that the composition of the present invention contains no polymer other than the polymer (A).

Cross-linking agent (H)

The composition according to the present invention can further comprise a cross-linking agent (H). Although not to be bound by theory, since the present invention is a positive type resist composition, there is no need to crosslink the exposed area, and film formation can be achieved without a cross-linking agent, so that a cross-linking agent is not essential. As an embodiment of the present invention, less content of the cross-linking agent is preferable for the composition.
The content of the cross-linking agent (H) is preferably 0 to 1.0 mass parts (more preferably 0 to 0.1 mass parts) with respect to 100 mass parts of the polymer (A). It is a preferred embodiment of the present invention that the composition of the present invention contains no cross-linking agent (H).

Plasticizer (I)

The composition according to the present invention can further comprise a plasticizer (I).
Including a plasticizer makes it possible to suppress the film cracking during thick film formation.
Examples of the plasticizer include alkali-soluble vinyl polymer and acid-dissociable group-containing vinyl polymer. More particular examples include polyvinyl chloride, polystyrene, polyhydroxystyrene, polyvinyl acetate, polyvinyl benzoate, polyvinyl ether, polyvinyl butyral, polyvinyl alcohol, polyether ester, polyvinylpyrrolidone, polyacrylic acid,

polymethacrylic acid, polyacrylic ester, polymaleimide, polyacrylamide, polyacrylonitrile, polyvinylphenol, novolak, and copolymer thereof; and polyvinyl ether, polyvinyl butyral and polyether ester are more preferable.

The content of the plasticizer (I) is preferably 0 to 1 mass parts (more preferably 0 to 0.1 mass parts) with respect to 100 mass parts of the polymer (A). It is a preferred embodiment of the present invention that the composition of the present invention contains no plasticizer (I).

Additive (J)

The composition according to the present invention can further comprise an additive (J). The additive (J) is at least one selected from the group consisting of an acid, a photoreaction quencher, a surface smoothing agent, a dye, a contrast enhancer, an acid, a radical generator, a substrate adhesion enhancer and an antifoaming agent.

The content of the additive (J) (in the case of a plurality of additives, the sum thereof) is preferably 0 to 5 mass % (more preferably 0 to 3 mass %; further preferably 0 to 1 mass %) based on the composition. It is also one embodiment of the present invention that the composition according to the present invention contains no additive (J) (0 mass %).

The acid can be used to adjust the pH value of the composition and improve the solubility of the additive components. The acid used is not particularly limited, but examples thereof include formic acid, acetic acid, propionic acid, benzoic acid, phthalic acid, salicylic acid, lactic acid, malic acid, citric acid, oxalic acid, malonic acid, succinic acid, fumaric acid, maleic acid, aconitic acid, glutaric acid, adipic acid, p-toluenesulfonic acid, camphorsulfonic acid, hydrates of any of these, and combinations of any of these. The content of the acid is preferably 0.005 to 0.1 mass % (more preferably 0.01 to 0.1 mass %) based on the composition.

The photoreaction quencher can be used to suppress deactivation of the acid on the resist film surface by components such as amine contained in the air, and is different from the photoacid generator (B). As a preferred embodiment of the present invention, the acid that directly acts on the polymer (A) is not the photoreaction quencher but the acid released from the photoacid generator (B).

The photoreaction quencher releases acid upon exposure. The acid preferably has an acid dissociation constant pKa($H_2O$) of 1.5 to 8 (more preferably 1.5 to 5).

The photoreaction quencher is composed of a cation and an anion, and exemplified embodiments of the cation and anion include the following:

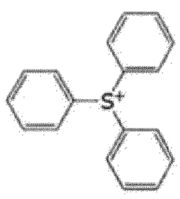
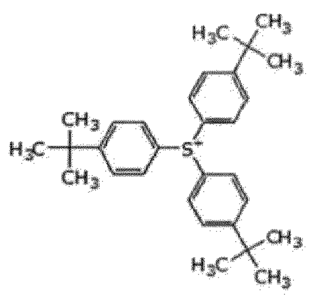
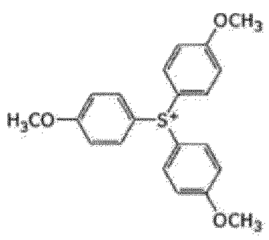
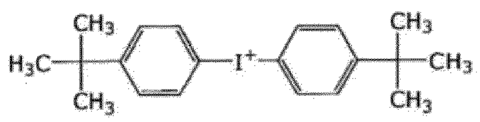
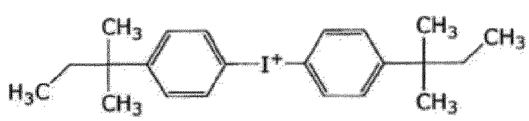

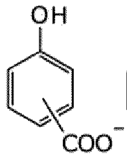 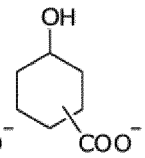 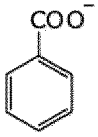 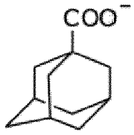 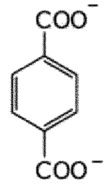 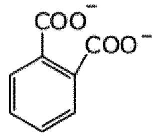

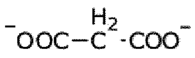 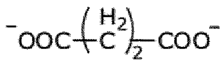 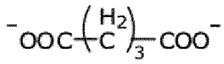 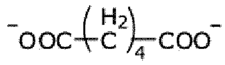

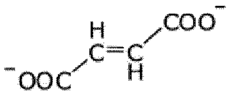 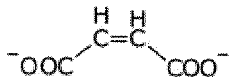 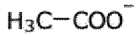 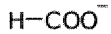

The composition according to the present invention is used to improve heat resistance, improve resolution, form a reverse tapered shape and/or reduce standing waves in a lithographic process. Preferably, the composition according to the present invention is used to improve resolution in a lithographic process.

<Method for manufacturing a resist pattern>

The method for manufacturing a resist pattern according to the present invention comprises the following steps:

(1) applying the composition according to the present invention above a substrate;
(2) heating the composition to form a resist layer;
(3) exposing the resist layer;
(4) post-exposure baking the resist layer; and
(5) developing the resist layer.

Although describing for clarity, the numbers in parentheses mean the order. For example, the step (1) is performed before the step (2).

Hereinafter, one embodiment of the manufacturing method according to the present invention is described.

The composition according to the present invention is applied above a substrate (for example, a silicon / silicon dioxide coated substrate, a silicon nitride substrate, a silicon wafer substrate, a glass substrate, an ITO substrate, and the like) by an appropriate method. In the present invention, the "above" includes the case where a layer is formed immediately on a substrate and the case where a layer is formed above a substrate via another layer. For example, a planarization film or resist underlayer can be formed immediately on a substrate, and the composition according to the present invention can be applied immediately on the film. The resist underlayer includes a BARC. The application method is not particularly limited, and examples thereof include a method using a spinner or a coater. After application, a film according to the present invention is formed by heating. The heating of (2) is performed, for example, by a hot plate. The heating temperature is preferably 100 to 250°C (more preferably 100 to 200°C; further preferably 100 to 160°C). The temperature here is a temperature of heating atmosphere, for example, that of a heating surface of a hot plate. The heating time is preferably 30 to 300 seconds (more preferably 30 to 120 seconds; further preferably 45 to 90 seconds). The heating is preferably performed in an air or a nitrogen gas atmosphere.

The thickness of the resist layer formed by the manufacturing method according to the present invention is preferably 50 to 1,500 nm.

The resist layer is exposed through a predetermined mask. The wavelength of light to be used for exposure is not particularly limited, but the exposure is preferably performed with light having a wavelength of 13.5 to 248 nm. Particularly, KrF excimer laser (wavelength: 248 nm), ArF excimer laser (wavelength: 193 nm), extreme ultraviolet (wavelength: 13.5 nm), or the like can be used, and KrF excimer laser is preferred. These wavelengths allow a range of ± 1%.

After exposure, a post-exposure bake (hereinafter sometimes referred to as PEB) is performed. The heating of (4) is performed, for example, by a hot plate. The temperature of the post exposure bake is preferably 80 to 160°C (more preferably 105 to 115°C), and the heating time is preferably 30 to 600 seconds (more preferably 45 to 120 seconds; further preferably 45 to 90 seconds). Heating is preferably performed in an air or a nitrogen gas atmosphere.

After the PEB, development is performed using a developer. As the developing method, any method conventionally used for developing a photoresist, such as a paddle developing method, an immersion developing method, or a swinging immersion developing method, can be used. As the developer, aqueous solution containing inorganic alkalis, such as sodium hydroxide, potassium hydroxide, sodium carbonate and sodium silicate; organic amines, such as

ammonia, ethylamine, propylamine, diethylamine, diethylaminoethanol and triethylamine; quaternary amines, such as tetramethylammonium hydroxide (TMAH); and the like are used, and a 2.38 mass % TMAH aqueous solution is preferable. A surfactant can also be further added to the developer. The temperature of the developer is preferably 5 to 50°C (more preferably 25 to 40°C), and the development time is preferably 10 to 300 seconds (more preferably 45 to 90 seconds). After development, washing with water or rinsing can also be performed as necessary. Since a positive type resist composition is used, the exposed area is removed by development to form a resist pattern. The resist pattern can also be further made finer, for example, using a shrink material.

The film thickness of the resist pattern formed is preferably 50 to 1,500 nm.

The shape of the resist pattern formed is not particularly limited as long as it is a shape suitable for lift-off, but it is preferably a reverse tapered shape.

In the present invention, the reverse tapered shape means that when a resist pattern 12 is formed on a substrate 11 as shown in the sectional view of Figure 1(A), the angle formed by a straight line (taper line), which connects the opening point (a boundary between the resist surface and the side of the resist pattern) 13 and the bottom point (a boundary between the substrate surface and the side of the resist pattern) 14, and the substrate surface is larger than 90 degrees, and the resist pattern does not substantially protrude to the outside of the taper line, that is, the resist pattern is not substantially thickened. This angle is referred to as the taper angle 15. Such a resist pattern is referred to as the resist pattern of reverse tapered shape 12. In the present invention, the reverse tapered shape not only means a reverse truncated cone but also includes the cases that, in a linear pattern, the line width of the surface part is wider than the line width in the vicinity of the substrate, or the like.

In the resist pattern of reverse tapered shape according to the present invention, as shown in the sectional view of Figure 1(B), the case where the resist pattern cavates to the inside from the straight line (taper line 24) connecting the opening point 22 and the bottom point 23, that is, the case where the resist pattern is thin, is also included. The taper angle here is the taper angle 25. Such a resist pattern is referred to as the resist pattern of overhanging shape 21. A straight line is drawn in parallel with the substrate surface at a position of the height of a half-length 27 of the resist pattern film thickness 26 from the substrate, and on the straight line, the distance between its intersection with the resist pattern and its intersection with the taper line is referred to as the bitten width 28. Similarly, on the straight line, the distance between its intersection with the resist pattern and its intersection with a straight line drawn perpendicularly to the substrate from the opening point is referred to as the taper width 29. The case where the bitten width / taper width is larger than 0 falls under Figure 1(B), and the case where it is 0 falls under Figure 1(A).

In the case of the overhanging shape, the remover tends to enter during resist removing after metal deposition, so that it is preferable.

As a modified example of the overhanging shape, a case where the end of the resist pattern 31 is rounded as shown in Figure 1(C) can also be thought. In this case, the opening point 32 is a boundary between the resist surface and the side of the resist pattern, and upon assuming a plane of the resist surface that is parallel to the bottom surface, it is a point where the resist pattern leaves the plane. The bottom point 33 is a boundary between the substrate surface and the side of the resist pattern. A straight line connecting the opening point 32 and the bottom point 33 is the taper line 34, and the taper angle here is the taper angle 35.

The area of the portion that is inside the taper line but is not the part of the resist pattern is referred to as $S_{in}$ 36, and the area of the portion that is outside the taper line but is the resist pattern is referred to as $S_{out}$ 37. In the case of a plurality, sum of the area is used.

$S_{out} / (S_{in} + S_{out})$ is preferably 0 to 0.45 (more preferably 0 to 0.1; further preferably 0 to 0.05; further more preferably 0 to 0.01). The shape having a small $S_{out} / (S_{in} + S_{out})$ is good because the remover can easily enter the resist side wall even if the metal is thickly deposited on the resist pattern.

$(S_{in} - S_{out}) / (S_{in} + S_{out})$ is preferably 0 to 1 (more preferably 0.55 to 1; further preferably 0.9 to 1; further more preferably 0.99 to 1). It is also a preferred embodiment of the present invention that $0 < (S_{in} - S_{out}) / (S_{in} + S_{out})$. When $(S_{in} - S_{out}) / (S_{in} + S_{out})$ is large, the resist pattern as a whole is dented to the inside from the taper line, and even if the metal is thickly deposited on the resist pattern, the remover can easily enter the resist side wall, so that it is preferable.

Upon applying the above to the case of the shapes of Figure 1(A) and Figure 1(B), both are $S_{out} / (S_{in} + S_{out}) = 0$, and both are $(S_{in} - S_{out}) / (S_{in} + S_{out}) = 1$.

As a preferred embodiment of the present invention, the width Wt of the upper portion of the resist pattern and the width Wb of the lower portion of the resist pattern satisfy
preferably $-50\ nm \leq (Wt - Wb)$; more preferably $0\ nm < (Wt - Wb)$; further preferably $50\ nm < (Wt - Wb)$. When a resist pattern of a reverse tapered shape can be formed, Wt > Wb is satisfied.

It is preferable to measure the conditions for comparing these numerical values as closely as possible to those in Examples described later. For example, it is preferable to compare by forming a film with a film thickness of 900 nm, and forming a resist pattern of trenches of 500 nm and 1:1.

$-10\% \leq (Wt - Wb) / Wt$ is preferred; $0\% < (Wt - Wb) / Wt$ is more preferred; and $10\% < (Wt - Wb) / Wt$ is further preferred.

Furthermore, a metal pattern can be manufactured by a method comprising:

(6) depositing a metal above the substrate using the resist pattern as a mask; and
(7) removing the resist pattern with a remover.

Using the resist pattern as a mask, a metal such as gold and copper (this can be a metal oxide or the like) is deposited above the substrate. In addition to deposition, sputtering can be used.
Thereafter, the metal pattern can be formed by removing the resist pattern together with the metal formed on its upper portion using the remover. The remover is not particularly limited as long as it is used as a remover for resist, but, for example, N-methylpyrrolidone (NMP), acetone, and an alkaline solution are used. Since the resist pattern according to the present invention has a reverse tapered shape, the metal on the resist pattern is separated from the metal formed on the area where the resist pattern is not formed, and therefore can be easily removed. The film thickness of the formed metal pattern can be increased, and a metal pattern having a film thickness of preferably 10 to 1,500 nm (more preferably 50 to 800 nm; further preferably 100 to 600 nm) is formed. Although not to be bound by theory, it can be thought that the resist pattern formed from the present composition is suitable for these lift-off processes due to good heat resistance thereof.
As another embodiment of the present invention, various substrates that serve as underlaying materials can also be patterned using the resist pattern formed up to the process (5) as a mask. The substrate can be directly processed using the resist pattern as a mask, or can be processed via an intermediate layer. For example, a resist underlayer can be patterned using the resist pattern as a mask, and the substrate can be patterned using the resist underlayer pattern as a mask. A known method can be used for processing, but a dry etching method, a wet etching method, an ion implantation method, a metal plating method, or the like can be used. It is also possible to wire electrodes or the like on the patterned substrate.
Thereafter, if necessary, further processing such as forming wiring on the processed substrate is performed to form a device. For these further processing, known methods can be applied. Examples of the device include a semiconductor device, a liquid crystal display device, an organic EL display device, a plasma display device, and a solar cell device. The device is preferably a semiconductor.

[Examples]

The present invention is described below with reference to various examples. The embodiment of the present invention is not limited only to these examples.

Preparation of Composition 1

A mass ratio of PGMEA : PGME = 30 : 70 is prepared and this is used as a mixed solvent. 100 mass parts of A1 as the polymer (A), 2.6 mass parts of B-1 as the photoacid generator (B), 0.32 mass parts of E as the basic compound (E), and 0.1 mass parts of F-1 as the surfactant (F) are added to the mixed solvent, respectively. The amount of addition is adjusted so that the solid component concentration becomes 16.5 mass %. The solid component concentration is calculated by "mass of all components excluding solvent / mass of whole composition". This is stirred for 30 minutes at room temperature. It is visually confirmed that the solute is dissolved. This is filtered through a 0.05 μm filter. Thereby, Composition 1 is obtained. The composition is listed in Table 1.
Each component used is as follows:
A1: hydroxystyrene : styrene : t-butyl acrylate copolymer, 6 : 2 : 2 molar ratio respectively, cLogP=2.79, Mw: 12,000.
The above ratio indicates the composition ratio of each repeating unit. The same applies to the following.

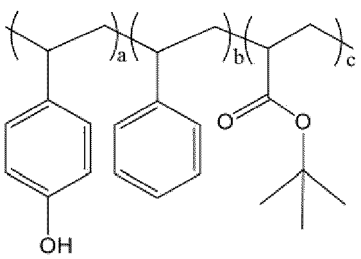

6:2:2

B-1 :

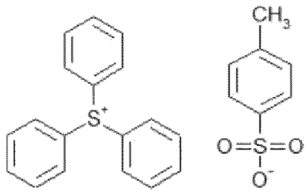

E: tris[2-(2-methoxyethoxy)ethyl]amine,
F-1: KP341, Shin-Etsu Chemical.

Preparation of Compositions 2 to 10 and Comparative Composition 1

By changing the components and amounts as shown in Table 1 and performing the same operation as in "Preparation of Composition 1", Compositions 2 to 10 and Comparative Composition 1 are obtained. In the following tables, the amount of each component is indicated by mass parts.

In Comparative Composition 1, a polymer is formed using A1 as the polymer (A) and G as the polymer (G) at a mass ratio of 1 : 1.

Each component used is as follows:

A2:

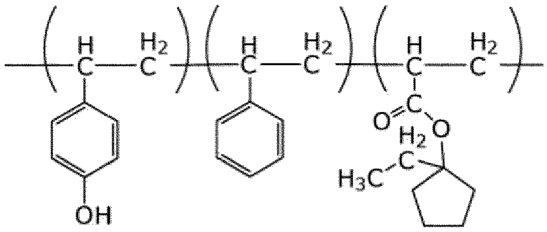

6 : 2 : 2, cLogP = 2.98, Mw: 12,000

A3:

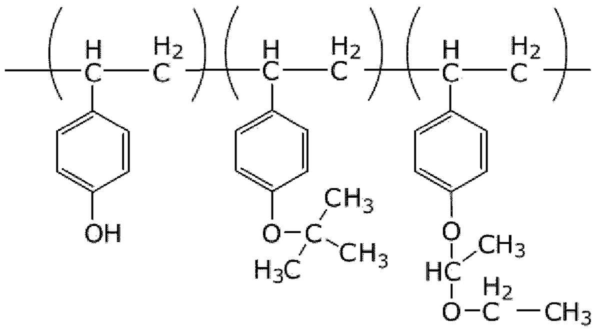

6 : 2 : 2, cLogP = 3.30, Mw: 12,000

G:

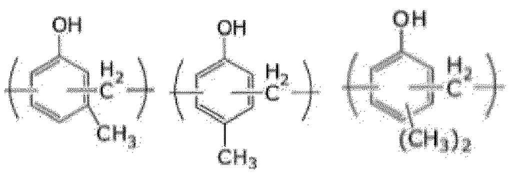

4 : 4 : 2, cLogP = 3.21, Mw: 5,000

B-2:

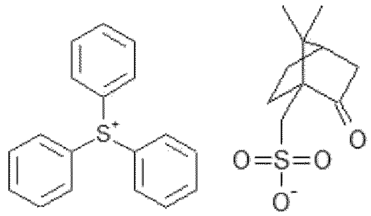

B-3:

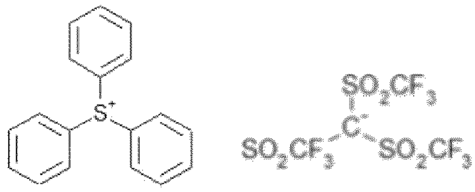

B-4:

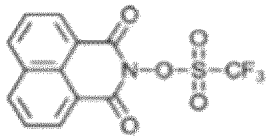

J: Camphorsulfonic acid

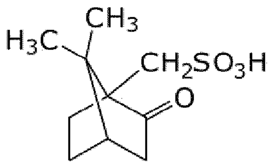

I: Lutonal, BASF

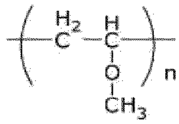

D: TPPA

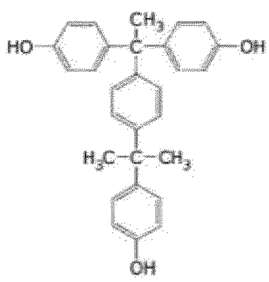

F-2: KF-53, Shin-Etsu Chemical

[Table 1]

| Table 1 | Polyme r (A) | | Photoacid generator (B) | | Solvent (C) | | Dissolut ion rate modifier (D) | | Basic compou nd (E) | | Surfacta nt (F) | | Polym er (G) | | Plastic izer (I) | | Additi ve (J) | |
|---|---|---|---|---|---|---|---|---|---|---|---|---|---|---|---|---|---|---|
| Compo sition 1 | A1 | 100 | B-1 | 2.6 | PGMEA:PGME | 30:70 | - | - | E | 0.32 | F-1 | 0.1 | - | - | - | - | - | - |
| Compo sition 2 | A1 | 100 | B-2 | 2.9 | PGMEA:PGME | 30:70 | - | - | E | 0.32 | F-1 | 0.1 | - | - | - | - | - | - |
| Compo sition 3 | A1 | 100 | B-3 | 4.0 | PGMEA:PGME | 30:70 | - | - | E | 0.32 | F-1 | 0.1 | - | - | - | - | - | - |
| Compo sition 4 | A2 | 100 | B-1 | 2.6 | PGMEA:PGME | 30:70 | - | - | E | 0.32 | F-1 | 0.1 | - | - | - | - | - | - |
| Compo sition 5 | A2 | 100 | B-2 | 2.9 | PGMEA:PGME | 30:70 | - | - | E | 0.32 | F-1 | 0.1 | - | - | - | - | - | - |
| Compo sition 6 | A2 | 100 | B-3 | 4.0 | PGMEA:PGME | 30:70 | - | - | E | 0.32 | F-1 | 0.1 | - | - | - | - | - | - |
| Compo sition 7 | A3 | 100 | B-1 | 2.6 | PGMEA:PGME | 80:20 | - | - | E | 0.32 | F-1 | 0.1 | - | - | - | - | - | - |
| Compo sition 8 | A3 | 100 | B-2 | 2.9 | PGMEA:PGME | 80:20 | - | - | E | 0.32 | F-1 | 0.1 | - | - | - | - | - | - |
| Compo sition 9 | A3 | 100 | B-3 | 4.0 | PGMEA:PGME | 80:20 | - | - | E | 0.32 | F-1 | 0.1 | - | - | - | - | - | - |
| Compo sition 10 | A2 | 100 | B-3 | 4.0 | PGMEA:PGME | 30:70 | - | - | E | 0.32 | F-1 | 0.1 | - | - | - | - | J | 0.2 |
| Compa rative compo sition 1 | A1 | 50 | B-4 | 1.6 | PGME:EL | 85:15 | D | 2.5 | E | 0.1 | F-2 | 0.1 | G | 50 | I | 5.0 | - | - |

<Formation of resist patterns from Compositions 1 to 10>

The surface of an 8-inch silicon wafer is subjected to HMDS treatment at 90°C for 60 seconds. Each composition is dropped onto the wafer and spin-coated. This wafer is baked on a hot plate at 110°C for 60 seconds to form a resist film. The thickness of the resist film at this point is each 900 nm when measured by an optical interference type film thickness measuring device M-1210 (SCREEN). The resist film is exposed using a KrF stepper (FPA3000-EX5, CANON). Dense Line (Line : Space = 1 : 1, Line = 500 nm) is used as the mask pattern. Thereafter, the wafer is subjected to baking (PEB) on a hot plate at 110°C for 60 seconds. This is puddle-developed with a 2.38 mass % TMAH aqueous solution for 60 seconds, rinsed with DIW, and spin-dried at 1,000 rpm. Thus, a resist pattern with a line width of 500 nm is obtained. The line width is measured at the upper portion of the resist pattern.

Figure 2 schematically shows a vertical cross-sectional shape of this pattern. A resist pattern 42 is formed on a substrate 41. The three figures show the cases where the widths of the upper portion 43 of the resist pattern are the same and the widths of the lower portion 44 of the resist pattern are different each other.

When the resist patterns of Compositions 1 to 10 and Comparative Composition 1 are formed, the exposure dose for forming a pattern with a line width of 500 nm at the upper portion of the resist pattern is taken as the optimum exposure dose. Using this optimum exposure dose, resolution, dimensional difference evaluation and heat resistance, which are described later, are evaluated.

<Formation of resist pattern from Comparative Composition 1>

Comparative Composition 1 is used, and except replacing the KrF stepper (FPA3000-EX5) with an i-line stepper (NSR-2205i11D, Nikon), the same operation is performed as the above-described "Formation of resist patterns from Compositions 1 to 10". Thereby, a resist pattern having a line width of 500 nm is obtained. The line width is measured at the upper portion of the pattern.

<Examples 101 to 110 and Comparative Example 101: Evaluation of resolution>

Using a mask pattern having a line width, a space width of 250 to 500 nm and line : space = 1 : 1, exposure is performed with the optimum exposure dose by the method for forming a pattern described above. The resolution is defined as the upper portion minimum dimension (nm) of the resist pattern that can be resolved when exposed with the optimum exposure dose. The dimension is measured by the length of the upper portion of the pattern. In the case that the pattern collapses or the space is crushed, it is treated as not being resolved. The smallest line width in which neither pattern collapse nor space crush is observed is adopted as the minimum dimension. The evaluation criteria are as follows.

A: less than 300 nm
B: 300 to 400 nm
C: larger than 400 nm

The results obtained are shown in Table 2.

[Table 2]

| Table 2 | | | Resolution |
|---|---|---|---|
| Example | 101 | Composition 1 | B |
| | 102 | Composition 2 | B |
| | 103 | Composition 3 | A |
| | 104 | Composition 4 | B |
| | 105 | Composition 5 | B |
| | 106 | Composition 6 | A |
| | 107 | Composition 7 | A |
| | 108 | Composition 8 | A |
| | 109 | Composition 9 | A |
| | 110 | Composition 10 | A |

(continued)

| Table 2 | | | Resolution |
|---|---|---|---|
| Comparative Example | 101 | Comparative composition 1 | C |

<Examples 201 to 210: Evaluation of dimensional difference>

A slice of a resist pattern sample with a line width of 500 nm is prepared, and the vertical cross section of the pattern is observed with a scanning type electron microscope (SU8230, Hitachi High-Tech). The cross-sectional shape of the resist pattern is confirmed using SU8230, and the dimensions of the upper portion and lower portion of the resist are measured. At this time, the dimension of the upper portion of the resist pattern is taken Wt, and the dimension of the lower portion thereof is taken Wb. The evaluation criteria are as follows.

A:

$$50\ \text{nm} < (Wt - Wb)$$

B:

$$-50\ \text{nm} \leq (Wt - Wb) \leq +50\ \text{nm}$$

C:

$$(Wt - Wb) < -50\ \text{nm}$$

The results obtained are shown in Table 3.

[Table 3]

| Table 3 | | | Dimensional difference |
|---|---|---|---|
| Example | 201 | Composition 1 | B |
| | 202 | Composition 2 | B |
| | 203 | Composition 3 | B |
| | 204 | Composition 4 | B |
| | 205 | Composition 5 | A |
| | 206 | Composition 6 | A |
| | 207 | Composition 7 | B |
| | 208 | Composition 8 | B |
| | 209 | Composition 9 | A |
| | 210 | Composition 10 | A |

<Examples 301 and 302, and Comparative Example 301: Evaluation of heat resistance>

Using the compositions described in Table 4, evaluation of heat resistance is performed. Wt is obtained from the cross-sectional shape of the resist pattern obtained in the "Evaluation of dimensional difference" described above. This is treated as Initial Wt. Another sample is prepared using a mask pattern with line width = 500 nm and space width = 500 nm (Line : Space = 1 : 1). This is subjected to additional heating using a hot plate under atmospheric condition for 180 seconds. The additional heating temperature varies from 120°C to 160°C by 10°C for each wafer. A vertical section of the pattern is obtained with SU8230, thereby getting Wt. This is treated as the additional bake Wt. Heating temperatures which satisfy the following are obtained:

(Initial Wt) - (additional bake Wt) ≥ 100 nm.

The evaluation criteria are as follows.

A: 150°C or higher
B: higher than 120°C and lower than 150°C
C: 120°C or lower

The results obtained are shown in Table 4.

[Table 4]

| Table 4 | | | Heat resistance |
|---|---|---|---|
| Example | 301 | Composition 6 | A |
| | 302 | Composition 10 | A |
| Comparative Example | 301 | Comparative composition 1 | C |

[Explanation of symbols]

11. substrate
12. resist pattern of reverse tapered shape
13. opening point
14. bottom point
15. taper angle
21. resist pattern of overhanging shape
22. opening point
23. bottom point
24. taper line
25. taper angle
26. resist pattern film thickness
27. half-length of resist pattern film thickness
28. bitten width
29. taper width
31. resist pattern
32. opening point
33. bottom point
34. taper line
35. taper angle
36. Sin
37. $S_{out}$
41. substrate
42. resist pattern
43. upper portion of resist pattern
44. lower portion of resist pattern

## Claims

**1.** A positive type lift-off resist composition comprising a polymer (A), a photoacid generator (B), a solvent (C) and, optionally, a dissolution rate modifier (D),
wherein,

cLogP of the polymer (A) is 2.76 to 3.35,
the polymer (A) comprises at least one of the repeating units represented by formulae (A-1) to (A-4),

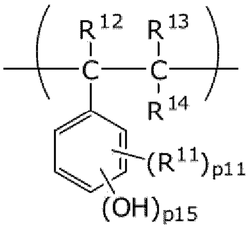

(A-1)

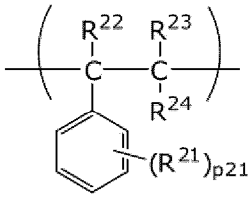

(A-2)

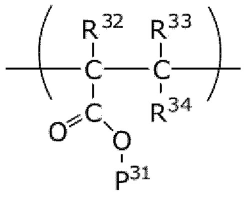

(A-3)

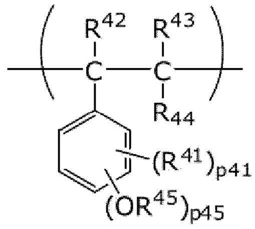

(A-4)

where

$R^{11}$, $R^{21}$, $R^{41}$ and $R^{45}$ are each independently $C_{1-5}$ alkyl (where - $CH_2$- in the alkyl can be replaced with -O-);
$R^{12}$, $R^{13}$, $R^{14}$, $R^{22}$, $R^{23}$, $R^{24}$, $R^{32}$, $R^{33}$, $R^{34}$, $R^{42}$, $R^{43}$ and $R^{44}$ are each independently hydrogen, $C_{1-5}$ alkyl, $C_{1-5}$ alkoxy or -COOH;
p11 is 0 to 4, p15 is 1 to 2, and p11 + p15 $\leq$ 5;
p21 is 0 to 5;
p41 is 0 to 4, p45 is 1 to 2, and p41 + p45 $\leq$ 5;
$P^{31}$ is $C_{4-20}$ alkyl (where a part or all of the alkyl can form a ring, and a part or all of H in the alkyl can be replaced with halogen);

and the content of the dissolution rate modifier (D) is 0 to 1.0 mass parts with respect to 100 mass parts of the polymer (A), and the dissolution rate modifier (D) is preferably represented by the formula (D-1):

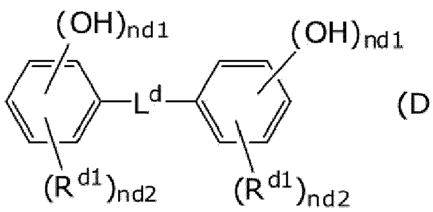

(D-1)

where

nd1 is each independently 1, 2 or 3,
nd2 is each independently 0, 1, 2 or 3,
$R^{d1}$ is each independently $C_{1-7}$ alkyl,
$L^d$ is $C_{1-15}$ divalent alkylene (which can be substituted with an optionally hydroxy-substituted aryl, and which can form a ring with a substituent other than $L^d$).

2. The composition according to claim 1, further comprising an acid selected from p-toluenesulfonic acid and camphorsulfonic acid, hydrates of these and combinations of these.

3. The composition according to claim 1 or 2, wherein $n_{A-1}$, $n_{A-2}$, $n_{A-3}$ and $n_{A-4}$, which are the numbers of repeating units represented by formulae (A-1), (A-2), (A-3) and (A-4) in the polymer (A) satisfy the following:

$$n_{A-1} / (n_{A-1} + n_{A-2} + n_{A-3} + n_{A-4}) = 40 \text{ to } 80\%,$$

$$n_{A-2} / (n_{A-1} + n_{A-2} + n_{A-3} + n_{A-4}) = 0 \text{ to } 40\%,$$

$$n_{A-3} / (n_{A-1} + n_{A-2} + n_{A-3} + n_{A-4}) = 0 \text{ to } 40\%,$$

or

$$n_{A-4} / (n_{A-1} + n_{A-2} + n_{A-3} + n_{A-4}) = 0 \text{ to } 60\%:$$

preferably, $n_{total}$, which is the number of all repeating units contained in the polymer (A), satisfies the following:

$$(n_{A-1} + n_{A-2} + n_{A-3} + n_{A-4}) / n_{total} = 80 \text{ to } 100\%.$$

**4.** The composition according to one or more of claims 1 to 3, wherein the photoacid generator (B) is represented by the formula (B-1) or comprises the structure of the formula (B-2):

$B^{n+}$cation $B^{n-}$anion (B-1)

wherein

the $B^{n+}$cation is a cation represented by the formula (BC1), a cation represented by the formula (BC2), a cation represented by the formula (BC3) or a cation represented by the formula (BC4), the $B^{n+}$cation is n valent as a whole, and n is 1 to 3, and
the $B^{n-}$anion is an anion represented by the formula (BA1), an anion represented by the formula (BA2), an anion represented by the formula (BA3), an anion represented by the formula (BA4) or an anion represented by the formula (BA5), and the $B^{n-}$anion is n valent as a whole:

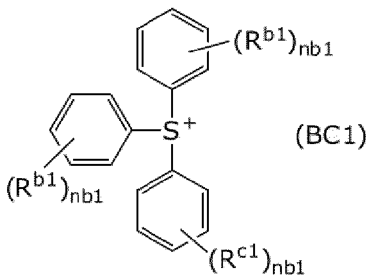
(BC1)

where

$R^{b1}$ is each independently $C_{1-6}$ alkyl, $C_{1-6}$ alkoxy, $C_{6-12}$ aryl, $C_{6-12}$ arylthio or $C_{6-12}$ aryloxy, and
nb1 is each independently 0, 1, 2 or 3;

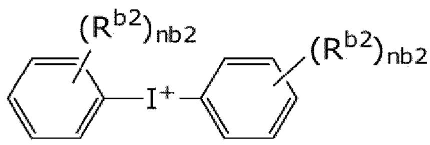
(BC2)

where

$R^{b2}$ is each independently $C_{1-6}$ alkyl, $C_{1-6}$ alkoxy or $C_{6-12}$ aryl, and
nb2 is each independently 0, 1, 2 or 3;

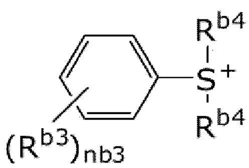
(BC3)

where

$R^{b3}$ is each independently $C_{1-6}$ alkyl, $C_{1-6}$ alkoxy or $C_{6-12}$ aryl,
$R^{b4}$ is each independently $C_{1-6}$ alkyl, and
nb3 is each independently 0, 1, 2 or 3;

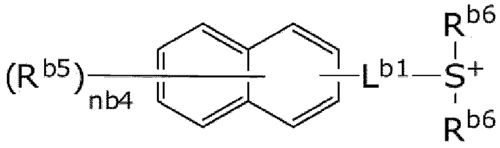

(BC4)

where

$L^{b1}$ is a single bond or $C_{1-3}$ divalent alkylene, and methylene in the alkylene can be replaced with carbonyl,
$R^{b5}$ is each independently $C_{1-6}$ alkyl, $C_{1-6}$ alkoxy or $C_{6-12}$ aryl;
$R^{b6}$ is each independently $C_{1-6}$ alkyl, and
nb4 is each independently 0, 1, 2 or 3;

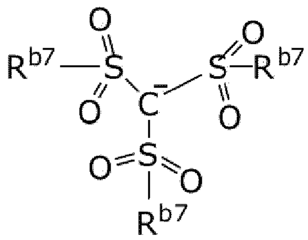

(BA1)

where
$R^{b7}$ is each independently fluorine-substituted $C_{1-6}$ alkyl, fluorine-substituted $C_{1-6}$ alkoxy, or $C_{1-6}$ alkyl;

$$R^{b8}-SO_3^- \quad (BA2)$$

where
$R^{b8}$ is fluorine-substituted $C_{1-10}$ alkyl, fluorine-substituted $C_{1-6}$ alkoxy, fluorine-substituted $C_{6-12}$ aryl, fluorine-substituted $C_{2-12}$ acyl or fluorine-substituted $C_{6-12}$ alkoxyaryl,

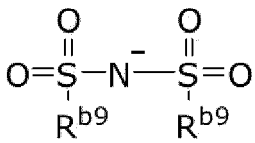

(BA3)

where
$R^{b9}$ is each independently fluorine-substituted $C_{1-6}$ alkyl, fluorine-substituted $C_{1-6}$ alkoxy, fluorine-substituted $C_{6-12}$ aryl, fluorine-substituted $C_{2-12}$ acyl or fluorine-substituted $C_{6-12}$ alkoxyaryl, where two $R^{b9}$ can be bonded to each other to form a fluorine-substituted heterocyclic structure;

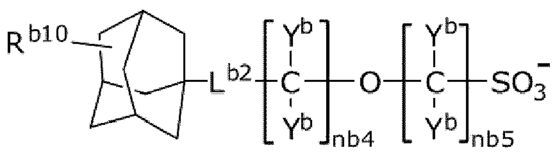

(BA4)

where

$R^{b10}$ is hydrogen, $C_{1-6}$ alkyl, $C_{1-6}$ alkoxy or hydroxy,
$L^{b2}$ is carbonyl, oxy or carbonyloxy,
$Y^b$ is each independently hydrogen or fluorine, nb4 is an integer of 0 to 10, and
nb5 is an integer of 0 to 21;

$$X^b-L^{b3}-SO_3^- \quad (BA5)$$

where

$L^{b3}$ is a single bond or $C_{1-3}$ divalent alkylene,
$X^b$ is an aromatic ring, a heteroaromatic ring, or an alicyclic ring, which ring can be substituted by one or more nitro, $C_{1-10}$ alkyl or fluorine-substituted $C_{1-6}$ alkyl, and a ring atom in the alicyclic ring can be replaced by carbonyl;

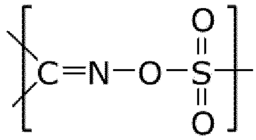 (B-2)

wherein the photoacid generator (B) preferably releases an acid having an acid dissociation constant pKa ($H_2O$) of -20 to 1.4 upon exposure:.

5. The composition according to one or more of claims 1 to 4, wherein the solvent (C) is water, a hydrocarbon solvent, an ether solvent, an ester solvent, an alcohol solvent, a ketone solvent, or any combination of any of these.

6. The composition according to one or more of claims 1 to 5, further comprising one or more of the following compounds:

a basic compound (E), wherein the basic compound (E) is preferably $C_{1-16}$ primary aliphatic amine compound, $C_{2-32}$ secondary aliphatic amine compound, $C_{3-48}$ tertiary aliphatic amine compound, $C_{6-30}$ aromatic amine compound or $C_{5-30}$ heterocyclic amine compound; and/or
a surfactant (F); and/or
a polymer (G), wherein the polymer (G) is different from the polymer (A):

preferably, cLogP of the polymer (G) is 2.76 to 3.35; wherein
preferably, the total mass Ma of the polymer (A) and the total mass Mg of the polymer (G) in the composition satisfy the following:

$$0 < Ma / (Ma + Mg) \leq 100\%,$$

and

$$0 \leq Mg / (Ma + Mg) < 70\%;$$

and/or
a cross-linking agent (H), wherein the content of the cross-linking agent (H) is preferably 0 to 1.0 mass parts with respect to 100 mass parts of the polymer (A); and/or
a plasticizer (I), wherein and the content of the plasticizer (I) is preferably 0 to 1.0 mass parts with respect to 100 mass parts of the polymer (A);
and/or
an additive (J), wherein the additive (J) is preferably at least one selected from the group consisting of an acid, a photoreaction quencher,
a surface smoothing agent, a dye, a contrast enhancer, an acid, a radical generator, a substrate adhesion enhancer and an antifoaming agent.

7. The composition according to claim 6, wherein the base dissociation constant pKb ($H_2O$) of the basic compound (E) is -12 to 5.

8. The composition according to one or more of claims 1 to 7, wherein the thickness of the resist film formed from the composition is 50 to 1,500 nm.

9. The composition according to one or more of claims 1 to 8, wherein,

the content of the polymer (A) is 1 to 20 mass % based on the composition,

the content of the photoacid generator (B) is 0.05 to 10 mass % based on the composition, and
the content of the solvent (C) is 80 to 98.95 mass % based on the composition:

preferably, the content of the basic compound (E) is 0 to 1 mass % based on the composition,
preferably, the content of the surfactant (F) is 0 to 3 mass % based on the composition,
preferably, the content of the polymer (G) is 0 to 10 mass % based on the composition, or
preferably, the content of the additive (J) is 0 to 5 mass % based on the composition.

**10.** The composition according to one or more of claims 1 to 9, which is a thin film positive type lift-off chemically amplified resist composition: preferably, the composition is a thin film KrF positive type lift-off chemically amplified resist composition.

**11.** Use of the composition according to one or more of claims 1 to 10 for improving heat resistance, improving resolution, forming a reverse tapered shape and/or reducing standing waves in a lithographic process.

**12.** A method for manufacturing a resist pattern, comprising the following steps:

(1) applying the composition according to one or more of claims 1 to 10 above a substrate;
(2) heating the composition to form a resist layer;
(3) exposing the resist layer;
(4) post-exposure baking the resist layer; and
(5) developing the resist layer;

wherein the film thickness of the resist pattern is preferably 50 to 1,500 nm; and/or
wherein the resist pattern is preferably a reverse tapered shape.

**13.** A method for manufacturing a metal pattern, comprising the following steps:

manufacturing a resist pattern by the method according to claim 12;
(6) depositing a metal above the substrate using the resist pattern as a mask; and
(7) removing the resist pattern with a remover;
wherein the film thickness of the metal pattern is preferably 10 to 1,500 nm.

**14.** A method for manufacturing a device comprising the method according to claim 12 or 13.

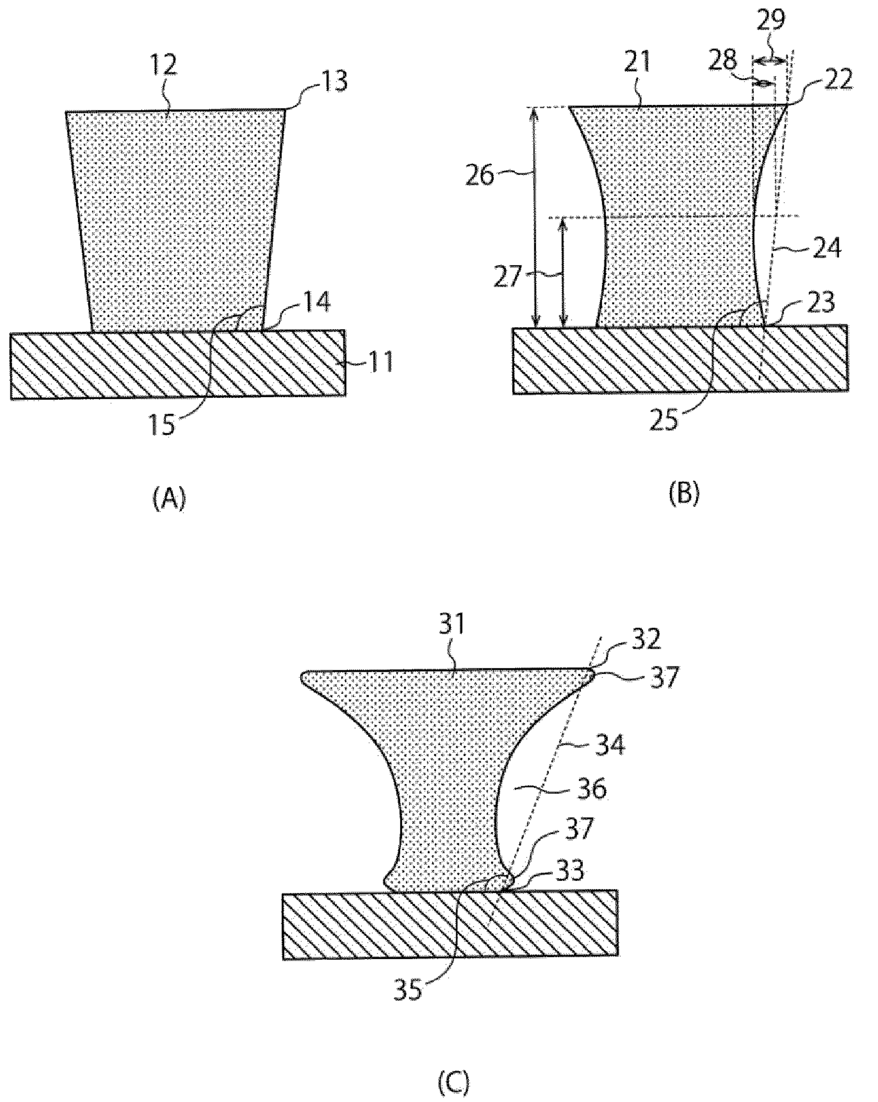


Figure 1

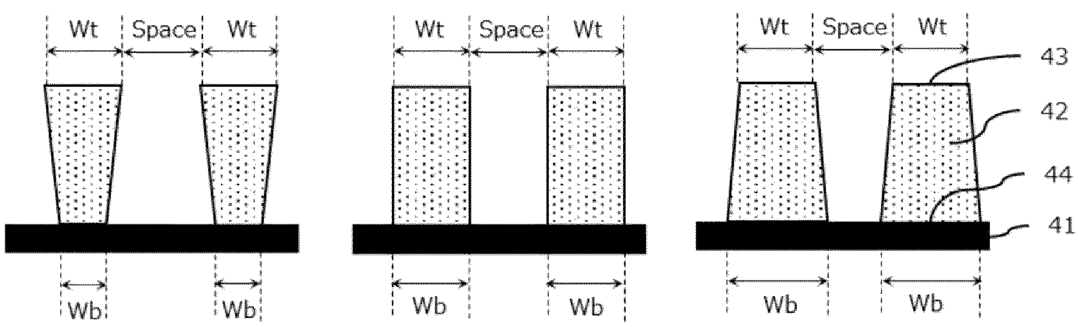


Figure 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017169866 A
- WO 2020193686 A


### Non-patent literature cited in the description


- **ARUP K. GHOSE et al.** Prediction of Hydrophobic (Lipophilic) Properties of Small Organic Molecules. *J. Phys. Chem. A*, 1998, vol. 102, 3762-3772